(19) Europäisches Patentamt
European Patent Office
Office européen des brevets

(11) **EP 1 660 306 B1**

(12) **FASCICULE DE BREVET EUROPEEN**

(45) Date de publication et mention
de la délivrance du brevet:
**02.03.2011 Bulletin 2011/09**

(21) Numéro de dépôt: **04786317.0**

(22) Date de dépôt: **17.08.2004**

(51) Int Cl.:
***B29C 67/00*** *(2006.01)*

(86) Numéro de dépôt international:
**PCT/FR2004/002150**

(87) Numéro de publication internationale:
**WO 2005/023523 (17.03.2005 Gazette 2005/11)**

(54) **PROCEDE DE FABRICATION D'UN COMPOSANT MULTIMATERIAUX TRIDIMENSIONNEL PAR IMPRESSION DU TYPE JET D'ENCRE**

VERFAHREN ZUR HERSTELLUNG EINES DREIDIMENSIONALEN FORMTEILS AUS MEHREREN MATERIALIEN DURCH TINTENSTRAHLDRUCKEN

METHOD FOR THE PRODUCTION OF A THREE-DIMENSIONAL MULTI-MATERIAL COMPONENT BY MEANS OF INK-JET-TYPE PRINTING

(84) Etats contractants désignés:
**AT BE BG CH CY CZ DE DK EE ES FI FR GB GR HU IE IT LI LU MC NL PL PT RO SE SI SK TR**

(30) Priorité: **29.08.2003 FR 0310300**

(43) Date de publication de la demande:
**31.05.2006 Bulletin 2006/22**

(73) Titulaire: **Centre National de la Recherche Scientifique (C.N.R.S.)**
**75016 Paris (FR)**

(72) Inventeurs:
• **LEJEUNE, Martine**
**F-87100 LIMOGES (FR)**
• **NOGUERA, Rémi**
**F-87000 LIMOGES (FR)**
• **CHARTIER, Thierry**
**F-87220 FEYTIAT (FR)**
• **OUDJEDI, Maksoud**
**F-87000 LIMOGES (FR)**

(74) Mandataire: **Novagraaf Technologies**
**122, rue Edouard Vaillant**
**92593 Levallois-Perret Cedex (FR)**

(56) Documents cités:
**US-A- 6 162 378    US-A1- 2002 167 101**

EP 1 660 306 B1

**Description**

La présente invention concerne un procédé et un dispositif de fabrication de composants multimatériaux tridimensionnels par impression du type jet d'encre de couches successives.

La fabrication de structures par impression du type jet d'encre est née de la nécessité de produire rapidement et simplement des objets multimatériaux et de haute définition aux formes complexes. Basée sur la conception assistée par ordinateur (CAO), cette fabrication permet de produire des objets, par adjonctions successives de matériaux, sans l'utilisation d'une étape de moulage ou d'utilisation d'outillage et fait partie des procédés de fabrication non soustractifs, c'est-à-dire sans prélèvement de matière afin d'obtenir la structure souhaitée.

Sa grande précision et les possibilités qu'elle offre en termes de définition intéressent de nombreux secteurs industriels positionnés sur les segments des micro composants tels que la micro électronique et les micro systèmes.

Il est par exemple possible de citer le domaine médical et la fabrication de sondes échographiques réalisées à partir de barreaux composites céramique/polymère de connectivité 1-3, dont les performances sont fonction de la taille, la qualité et de la densité d'intégration de barreaux céramiques qui les constituent.

La fabrication de composants multimatériaux par impression du type jet d'encre pose plusieurs problèmes que l'on peut généralement classer en trois catégories.

La première catégorie tient à la nature des matériaux utilisés au cours de la fabrication, la seconde aux propriétés du dispositif d'impression, et la dernière au procédé CAO mis en oeuvre, chacune ayant une incidence directe sur la qualité du composant fabriqué.

La nature des matériaux, notamment des systèmes céramiques, caractérisés par leurs propriétés d'homogénéité, taille des particules de céramique, propriétés rhéologiques etc... influe sur la manière dont ces gouttes devant être éjectées vont se former, leur impact et étalement sur la surface de dépôt et l'évaporation éventuelle du solvant entrant dans leur constitution. Elles agissent également directement sur l'arrangement relatif des particules dans le composant fabriqué.

Des caractéristiques mal ou imprécisément définies peuvent donc limiter la qualité du composant fabriqué, en termes de cohésion et de fragilité, de définition de précision ou de caractéristiques mécaniques de ces éléments constitutifs par exemple.

La nature des matériaux est également importante au regard du dispositif d'impression mis en oeuvre.

De façon classique, un dispositif d'impression comporte des moyens de stockage, d'écoulement et d'éjection de matériaux ainsi que des moyens de déplacement pour permettre l'éjection de produit à des endroits souhaités.

Dans l'hypothèse où les systèmes céramiques présentent de mauvaises caractéristiques pour le dispositif d'impression, par exemple une sédimentation non souhaitée, susceptible de provoquer l'obstruction de canaux d'écoulement, ce dispositif d'impression peut fonctionner de manière non satisfaisante, voire présenter des défaillances. Ceci a pour conséquence une fabrication de composants de mauvaise qualité, indépendamment de la précision dont est capable ce dispositif. C'est pourquoi, il est important de maîtriser la nature des matériaux dans le dispositif d'impression, pour à la fois fournir des matériaux présentant les propriétés requises pour l'impression et utiliser de façon optimale les différentes fonctions du dispositif d'impression.

Bien entendu, la qualité obtenue pour un composant ne dépend pas uniquement d'une commande appropriée de la nature des matériaux devant être éjectés.

Même pour une gestion optimale de cette dernière, si le dispositif ne permet pas, par exemple, les précisions d'exécution requises par le cahier des charges de fabrication, il est impossible de fabriquer un composant de bonne qualité conforme aux spécifications de ce dernier.

La précision d'exécution est certes directement liée à la précision des déplacements et des conditions d'éjection des matériaux mais également à la façon dont ceux-ci sont commandés. Ainsi, par exemple, peu importe que le dispositif soit capable de former des gouttes de matériaux de diamètre $10\mu m$, si ces gouttes sont éjectées au mauvais endroit ou à une mauvaise distance par rapport à la surface de dépôt.

Ainsi, non seulement la nature des matériaux utilisés pour la fabrication doit être sélectionnée de façon appropriée, mais encore les conditions de leur dépôt doivent l'être également.

En outre, se posent les problèmes liés à la conception CAO de l'objet à fabriquer. De façon classique, celle-ci consiste à découper une représentation de l'objet à fabriquer en couches d'impression successives et à définir, pour chaque couche, des motifs devant être imprimés par le dispositif d'impression. Une conception CAO qui ne tient pas compte des propriétés du dispositif et des propriétés des matériaux ne permet pas de définir de manière optimale les motifs à imprimer.

Enfin, prendre en compte de manière indépendante les problèmes décrits ci-dessus, limite la qualité de l'objet à fabriquer car cette qualité est fonction de l'ensemble des paramètres liés représentatifs à la fois de la nature des systèmes céramiques utilisés, des propriétés du dispositif d'impression et de la conception CAO.

Il est connu dans la littérature des dispositifs de fabrication de composants multimatériaux par impression du type jet d'encre, comme par exemple ceux décrits dans les articles de M. Motte et al, J. Am. Ceram. Soc., 80[2], 1997, 486-494 et de J.H. Song et al, Journal of Materials Science, n˚37 (2002). Toutefois chacun ne traite que partiellement et de façon sensiblement indépendante les problèmes précités.

Ainsi, le premier dispositif, s'il comporte une hauteur d'éjection réglable, celle-ci est commandée de façon manuelle au début de l'impression. Il en résulte un mauvais impact des gouttes dont les conditions d'éjection et de dépôt dégradent la structure du composant à fabriquer. De plus bien que ce document aborde les problèmes rhéologiques; tension superficielle, et de taux de séchage, il ne présente pas de solution permettant de commander les conditions d'éjections en fonction de ces paramètres afin d'obtenir une bonne qualité de produit à éjecter.

Le second document présente un dispositif d'impression du type jet d'encre comportant une multitude de buses d'éjection pour la production de matrices de barreaux en céramique. Ces buses sont disposées en lignes et le dispositif ne dispose que d'un seul degré de liberté dans le plan d'impression. Par ailleurs, les problèmes de tension de surface, viscosité et sédimentation sont résolus par un système de va-et-vient de matériaux dans la tête d'éjection à des moments prédétermines si bien qu'entre deux moments prédétermines, lesdites caractéristiques de dépôt du matériau et du matériau déposé ne sont pas commandées. La qualité d'éjection n'est alors pas commandée de façon continue dans le temps.

Le document US-A-2002/167101 décrit un appareil et un procédé de moulage d'objet 3D selon le préambule de la revendication 1, présentant un réservoir supportant une résine incolore ou blanche représentant un premier matériaux destiné à être utilisé pour le moulage de la surface intérieur ainsi qu'un réservoir supportait de la résine de couleur représentait un second matériaux destiné à être utilisés pour le moulage de la surface extérieur. Ces matériaux de résine sont-projetés par des buses d'éjection en direction d'un plateau. Un unité de contrôle est utilisée pour déplacer une tête d'éjection dans le plan XY et contrôler les jets de matériaux de résine depuis les buses d'éjection.

Le but de la présente invention est de résoudre les problèmes susmentionnés en proposant un procédé et un dispositif de fabrication par impression du type jet d'encre qui permettent de fabriquer des structures tridimensionnelles constituées de plusieurs matériaux distincts.

Le dispositif selon la présente invention permet également d'atteindre des précisions de fabrication de l'ordre du micromètre, ce qui *permet d'obtenir des structures de grande définition.

La présente invention a ainsi pour principal objet un procédé de fabrication d'un composant multimatériaux tridimensionnel par impression du type jet d'encre de gouttes d'au moins un matériau en couches successives selon la revendication 1.

Les revendications 2 à 5 présentent d'autres caractéristiques du procédé selon la revendication 1.

La présente invention sera mieux comprise à la lecture de la description qui va suivre, donnée à titre d'exemple, prise en relation avec les dessina annexés dans lesquels :

- la figure 1 est un schéma bloc d'une partie des étapes du procédé selon l'intention;
- la figure 2 représente une vue en perspective d'un composant multimatériaux entrant dans la constitution d'une sonde échographique ;
- la figure 3 est un ensemble de trajectoires spatiales discrètes d'une couche d'impression obtenu par l'étape de détermination des trajectoires spatiales discrètes du procédé selon l'invention ;
- la figure 4A est un ensemble de trajectoires spatiales discrètes d'une couche d'impression utilisé pour déterminer les trajectoires spatiales discrètes de la couche d'impression suivante;
- la figure 4B est un ensemble de trajectoires de la couche d'impression suivante obtenu par l'étape de détermination des trajectoires spatiales discrètes du procédé selon l'invention à partir d'une rotation des trajectoires de la couche 5A :
- la figure 5 est un schéma de principe d'un dispositif d'impression selon l'invention ;
- la figure 6 est un schéma de principe de l'unité de traitement d'informations entrant dans la constitution du dispositif d'impression de la figure 5;
- la figure 7 est une vue schématique d'un réservoir de stockage de matériaux pour dispositif d'impression du type jet d'encre entrant dans la constitution du dispositif d'impression de la figure 5 ;
- la figure 8 est une vue schématique d'une tête d'impression pour dispositif d'impression du type jet d'encre entrant dans la constitution du dispositif d'impression du type jet d'encre de la figure 5 ;

Avant de décrire plus en détail des modes de réalisation du procédé et du dispositif selon l'invention, quelques définitions sont préalablement introduites pour une meilleure compréhension de la description qui suivra.

De manière classique, il existe une hiérarchisation des ensembles dans le domaine de la fabrication par impression du type jet d'encre. Le composant désigne la structure totale fabriquée lors d'une fabrication complète. Un composant peut être constitué d'une ou plusieurs pièces. Par exemple, la fabrication d'un composant peut consister en la production d'une série de plusieurs sondes échographiques ou en la production d'une sonde échographique et d'un micro-moteur. Chaque pièce est composée d'un ou plusieurs objets. Par exemple, une sonde échographique comprend des barreaux de céramique, qui constituent chacun un objet de la sonde. Enfin chaque objet est constitué de zones remarquables, par exemple le coeur qui constitue le coeur de l'objet, la peau qui constitue la couche limite de l'objet hormis l'enveloppe et l'enveloppe qui correspond à la couche de l'objet en contact avec l'environnement d'impression lors de la fabrication, notamment la table d'impression du dispositif d'impression ou encore l'air quand le composant multimatériaux est fabriqué à l'air libre.

Comme il sera expliqué plus en détail par la suite, le procédé selon l'invention considère un nombre d'ensembles et subdivisions plus restreint puisqu'il n'utilise que deux partitions du composant : une partition du composant en « objets remarquables» définis en tant qu'entités géométriques et physico-chimiques et une partition d'un objet remarquable en « couches d'impression » définies en tant qu'entités de fabrication au cours du procédé objet de l'invention.

Pour déterminer les couches d'impression, le mode de réalisation du procédé selon l'invention introduit des « couches d'objet» qui résultent d'un tranchage de la représentation 3D du composant en tranches d'égale épaisseur et par conséquent des objets remarquables, et qui sont ici utilisées pour la détermination des couches d'impression.

Un composant est par ailleurs caractérisé par un ensemble de propriétés. Ces propriétés sont obtenues à la suite d'un processus dynamique de fabrication. Les propriétés caractérisant le composant une fois fabriqué seront donc qualifiées de « propriétés statiques » par opposition au processus dynamique de fabrication. Par ailleurs, il est possible de commander le processus dynamique de fabrication via différents paramètres de commande qui seront qualifiés de « paramètres d'impression ». Enfin le processus dynamique de fabrication se déroule dans un environnement particulier. Cet environnement est caractérisé par un ensemble de propriétés qui sont qualifiées de « conditions de dépôt ».

De façon classique, la fabrication d'un composant est précédée d'une étape de conception assistée par ordinateur qui consiste en la réalisation d'une représentation tridimensionnelle (ci-après « 3D ») de cet objet à partir d'un cahier des charges regroupant l'ensemble des spécifications et propriétés devant être remplies par celui-ci.

A partir de cette représentation 3D et du cahier des charges, le procédé selon l'invention détermine un ensemble de caractéristiques pour l'impression.

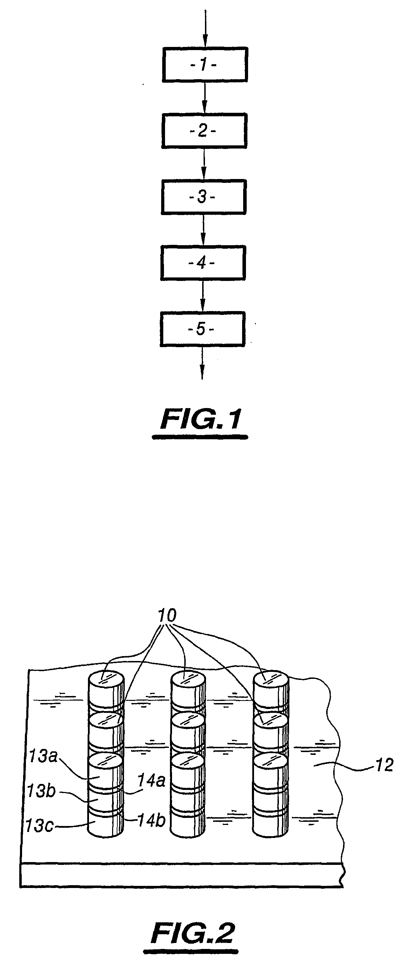

La figure 1 est un schéma bloc de premières étapes du procédé selon l'invention mises en oeuvre lors de la détermination de l'ensemble des caractéristiques du cycle de fabrication du composant. Une première étape 1 du procédé permet de découper la représentation 3D en un ensemble d'objets remarquables. Cet ensemble d'objets remarquables est alors utilisé pour trancher, dans une étape de tranchage 2 du procédé, la représentation 3D du composant à fabriquer et pour ainsi obtenir un ensemble de couches d'impression devant être imprimées de manière successive. Dans une étape 3, le procédé permet de calculer un ensemble de trajectoires spatiales discrètes par couche d'impression. L'étape 4 consiste à déterminer un ensemble de paramètres d'impression pour chaque couche d'impression et chaque trajectoire spatiale et temporelle. L'étape 5 suivante du procédé, consiste à établir une loi de séquencement spatial et temporel de parcours d'impression des couches d'impression et des trajectoires spatiales discrètes alors déterminées.

Chacune de ces étapes est à présent décrite plus en détail ci-dessous.

Etape de découpage de la représentation 3D en objets remarquables

La première étape 1 du procédé selon l'invention est donc l'étape de découpage de la représentation 3D du composant à fabriquer qui consiste à découper la représentation 3D du composant à fabriquer par impression du type jet d'encre en objets remarquables. Un objet remarquable est défini par un ensemble de propriétés géométriques et de propriétés physico-chimiques prises en combinaison.

Un objet géométrique est une région spatialement continue du composant, c'est-à-dire d'un seul tenant. Un objet physico-chimique est une région du composant qui présente un arrangement de particules constant présentant une micro-structure particulière et qui est constituée d'un seul matériau. Un objet remarquable est à la fois un objet géométrique et un objet physico-chimique. Chacun des objets remarquables d'un composant et les propriétés qui le définissent sont déterminés lors de la définition du cahier des charges de fabrication du composant multimatériaux à fabriquer.

La figure 2 représente une vue en perspective d'un élément entrant dans la constitution d'une sonde échographique, à savoir un réseau 10 de barreaux. Chacun des barreaux est constitué d'une alternance de couches d'un matériau céramique 13a, 13b, 13c, par exemple de la PZt choisie pour ses propriétés piézoélectriques, et de couches d'un matériau conducteur 14a, 14b, par exemple de l'alliage argent-paladium qui forme une électrode. Le procédé identifie les objets remarquables de cette représentation 3D et découpe celle-ci en conséquence.

Par exemple, en supposant que le réseau 10 de barreau soit composé de neuf barreaux, un total de 45 objets remarquables peut être ainsi obtenu. En effet, en émettant l'hypothèse que les différentes couches de matériaux entrant dans la constitution des barreaux du réseau 10 de barreaux présentent chacune un arrangement de particules constant, dix huit objets correspondent à chacune des couches en matériau conducteur constitutives des barreaux et 27 objets correspondent aux couches en matériau céramique constitutives des barreaux.

Chacun des objets ci-dessus peut encore être découpé, quand cela est nécessaire, c'est-à-dire imposé par le cahier des charges de fabrication et/ou le processus de fabrication, en 3 objets aux propriétés mécaniques différentes, d'où les hypothèses introduites ci-dessus. En effet, la couche périphérique de ces objets n'est pas soumise aux mêmes contraintes, par exemple mécaniques et/ou thermiques, que la partie qui forme le coeur. Une différence est par exemple le fait que la couche périphérique est en contact avec l'air ambiant, si ce réseau est fabriqué à l'air libre. Par ailleurs, la couche périphérique peut avoir une fonction spécifique, comme celle consistant à former un espace de fabrication pour le coeur de l'objet, ce qui lui impose de posséder des propriétés différentes que celles du coeur.

Ainsi, il est encore possible de distinguer trois objets remarquables pour chacun des objets décrit ci-dessus : la partie libre, la ou les parties en contact avec un autre matériau et la partie formant le coeur (peau, enveloppe et coeur respectivement). Si le cahier des charges de fabrication et/ou le processus de fabrication imposent des propriétés spécifiques pour chacune des ces régions, le procédé selon l'invention permet alors de les identifier et de découper la représentation 3D en conséquence.

Une fois le découpage de la représentation 3D du composant terminé, le procédé dispose donc d'un ensemble d'objets remarquables auxquels sont associés des ensembles de propriétés géométriques et physico-chimiques les définissant.

Cependant, ces propriétés sont des propriétés statiques, qui définissent le composant une fois fabriqué. Or ces propriétés sont obtenues à la suite d'un processus dynamique de fabrication et dépendent à la fois des caractéristiques physico-chimiques des matériaux déjà déposés ou à déposer, des caractéristiques du dispositif d'impression utilisé pour la fabrication du composant et des caractéristiques de l'interaction des matériaux avec le dispositif d'impression utilisé pour la fabrication.

Par exemple, lorsqu'une goutte de matériau est déposée sur une surface dite de dépôt, le matériau qu'elle contient va s'étaler, ce qui constitue un processus dynamique. Plus l'étalement d'une goutte déposée est prononcé et plus l'épaisseur de matériau finalement obtenue pour une goutte déposée est faible et inversement, ce qui conditionne par conséquent l'arrangement final des particules des matériaux déposés, ce qui constitue une propriété statique. Les caractéristiques physico-chimiques des matériaux utilisés pour la fabrication peuvent également conditionner la taille et la forme des gouttes éjectées par les moyens d'éjection du dispositif d'impression. Par exemple, avec une buse d'éjection spécifique il sera impossible d'éjecter des gouttes d'un matériau inférieures en diamètre à $20\mu$m, imposant ainsi un volume minimum du matériau déposable par goutte éjectée.

De la même manière, la hauteur d'éjection, définie comme étant la distance orthogonale à la surface de dépôt entre la surface de dépôt et les buses d'éjection, des gouttes joue aussi un rôle déterminant. Cette hauteur détermine en partie les caractéristiques de l'impact des gouttes sur la surface de dépôt et donc la forme initiale de la goutte sur la surface de dépôt, ainsi que la dispersion initiale du matériau sur la surface de dépôt. Si cette hauteur d'éjection n'est pas commandée, le contrôle de l'impact est alors restreint.

Le procédé selon l'invention permet alors de tenir compte des facteurs définis ci-dessus pour optimiser l'impression. Il est possible d'influer sur certains de ces facteurs par la commande de certains paramètres concernant l'état des matériaux et du dispositif d'impression. Ainsi, en contrôlant la température du matériau dans les moyens d'éjection, et donc lors de l'éjection des gouttes de matériau, on contrôle son évaporation et sa viscosité au contact du support, et par conséquent l'étalement des gouttes déposées. Par ailleurs, commander la température dans les moyens d'éjection permet d'utiliser ceux-ci dans leur état de fonctionnement optimal. De même, il est particulièrement avantageux de commander des paramètres du dispositif tel que la hauteur d'éjection ou le volume des gouttes éjectées.

Les paramètres commandables, que ce soit les paramètres d'état des matériaux ou des paramètres de fonctionnement du dispositif d'impression, constituent par conséquent les paramètres d'impression.

L'ensemble des propriétés, paramètres, caractéristiques, facteurs relatifs aux matériaux, au dispositif d'impression, à l'environnement qui influent sur les facteurs décrits ci-dessus, mais qui ne sont pas commandables, constituent quant à eux les conditions de dépôt. Il s'agit notamment de la taille et de l'agencement des canalisations du dispositif. Il peut également s'agir, lorsque l'on considère l'éjection d'une goutte particulière, de la nature de la surface de dépôt, qui, pour cette éjection considérée, est fixée et ne peut être changée.

Une fois déterminé l'ensemble des objets remarquables du composant à fabriquer, le procédé permet alors d'identifier l'ensemble des paramètres d'impression à commander pour obtenir, pour des conditions de dépôt prédéterminées, les propriétés statiques souhaitées du composant à fabriquer.

Etape de tranchage de la représentation 3D du composant

L'étape 2 suivante du procédé est l'étape de tranchage de la représentation 3D du composant en couches d'impression et consiste à trancher la représentation 3D du composant à fabriquer en couches d'impression devant être imprimées successivement. Ce tranchage est réalisé en fonction des objets remarquables et de leurs propriétés statiques souhaitées et en fonction des caractéristiques dynamiques du processus d'impression, qui, une fois stabilisé, assure les propriétés statiques requises du composant. Cette étape consiste à maximiser les épaisseurs des couches d'impression pour obtenir une fabrication la plus rapide et la plus homogène possible.

L'étape de tranchage permet tout d'abord de positionner la représentation 3D du composant dans un volume de fabrication. Par exemple, il peut s'agir d'une représentation de la région de l'espace atteignable par les moyens d'éjection. Ce volume comprend de façon classique un plan représentatif du plan de la table d'impression du dispositif d'impression sur lequel est positionnée la représentation 3D. Ce volume d'impression est repéré par un repère orthogonal formé de trois axes X, Y et Z qui sont chacun une représentation d'un axe de déplacement des moyens d'éjection du dispositif d'impression selon l'invention, comme cela sera décrit plus en détail par la suite, et dont l'origine peut être, par exemple, représentative d'une position de repos des moyens d'éjection. Un axe préférentiel est alors choisi pour déterminer la direction selon laquelle sera effectuée l'impression, c'est-à-dire la direction de superposition des couches d'impression, et donc la direction de tranchage, par exemple l'axe Z. Dans la description qui va suivre, les épaisseurs seront considérées selon cet axe Z d'impression.

L'étape de tranchage consiste ensuite à définir une épaisseur minimale de couche d'impression. Il s'agit de l'argument h* du problème d'optimisation selon la relation:

$$h^* = \arg \min_i \left( \max \left( \min(h_i / C_i), h_i^* \right) \right)$$

où i est l'entier représentatif du $i^{\text{éme}}$ objet remarquable du composant à fabriquer, $h_i$ est l'épaisseur de matériau déposable pour le $i^{\text{éme}}$ objet telle que les propriétés Ci statiques souhaitées pour cet objet soient satisfaites, et $h_i^*$ est l'épaisseur minimale que le dispositif peut déposer pour le matériau entrant dans la constitution de ce $i^{\text{éme}}$ objet.

Pour déterminer les valeurs $\min(h_i/C_i)$, c'est-à-dire l'épaisseur minimale pour atteindre la propriété Ci, il est possible de mener des études préliminaires et stocker les résultats de ces études dans une base de données et de les charger lors de la mise en oeuvre de cette étape de détermination de l'épaisseur minimale d'impression. Si de telles études n'ont pas été menées, ce problème est résolu en émettant des heuristiques communément utilisées dans le domaine de la fabrication de composant par impression du type jet d'encre, par exemple l'heuristique telle que $\min(h_i/C_i)$ = $h_i^*$ ou $\min(h_i/C_i)$ est l'épaisseur la plus faible de l'objet remarquable quand celle-ci est de l'ordre de $h_i^*$.

Il est à noter que le procédé tient compte de la flexibilité offerte par le dispositif d'impression de déposer des épaisseurs de matériaux dans une gamme d'épaisseur étendue de sorte que cette épaisseur h* minimale de couche d'impression est une épaisseur déposable pour chaque matériau. Pour cela on choisit, quel que soit le $i^{\text{éme}}$ objet constitutif du composant à fabriquer, $h_i^* = k_i \times \tilde{h}$ où $k_i$ est un entier naturel supérieur ou égal à un et $\tilde{h}$ est une épaisseur déposable pour tous les matériaux entrant dans la fabrication du composant. Cette condition peut ainsi être introduite dans le problème d'optimisation mentionné ci-dessus.

On voit là tout l'intérêt du procédé d'impression du type jet d'encre selon l'invention qui tient compte des propriétés du dispositif pour optimiser au mieux la fabrication de composants multimatériaux.

Le procédé selon l'invention permet d'associer à chaque objet remarquable déterminé lors de l'étape de découpage de la représentation 3D du composant des intervalles de valeurs admissibles de paramètres d'impression. Ces intervalles sont déterminés en fonction des propriétés statiques souhaitées, pour le composant et des conditions de dépôt prédéterminées. Ces intervalles portent notamment sur le volume déposé des matériaux sur la surface de dépôt ou de manière équivalente vu du dispositif d'impression sur la taille et la forme des gouttes de matériaux éjectées, la hauteur d'éjection des gouttes par rapport à la surface de dépôt, la distance séparant deux éjections successives de gouttes de matériau, la température et la pression des matériaux lors de l'éjection. Ces intervalles sont déterminés de telle sorte que quelles que soient les valeurs de paramètres d'impression choisies dans ceux-ci, aux conditions de dépôt prédéterminées, les propriétés statiques souhaitées pour l'objet sont satisfaites.

Ces intervalles de paramètres peuvent provenir d'études antérieures, être stockés dans une base de données, et chargés au cours ou antérieurement à l'étape de tranchage. Ces intervalles peuvent être également définis par les utilisateurs du procédé et dispositif selon l'invention en fonction de leur savoir-faire et chargés par eux lors de l'étape de tranchage ou à l'initialisation du procédé en les incorporant, par exemple, au cahier des charges du composant multimatériaux à fabriquer. Il est à noter qu'une partie ou l'ensemble de ces intervalles de paramètres d'impression peut se réduire à un ensemble de points, ce qui signifie, que dans les conditions de dépôt prédéterminées, l'obtention des propriétés statiques nécessite pour certains ou tous les paramètres d'impression une valeur unique.

L'éjection de gouttes de matériaux pour un jeu de valeurs de paramètres d'impression choisi dans cet ensemble d'intervalles induit un étalement des gouttes déposées particuliers et par conséquent une épaisseur finale de matériau déposé. Ainsi l'image de cet ensemble d'intervalles de paramètres d'impression par le processus d'éjection suivi du processus de dépôt ou impact, et du processus d'étalement et de séchage des gouttes de matériau est un intervalle d'épaisseur de matériau déposable.

Ainsi quel que soit le $i^{\text{ème}}$ objet remarquable constitutif du composant à fabriquer, on peut associer une valeur

d'épaisseur $e_i$ maximale de matériau déposable et un intervalle d'épaisseur définie par $[h_i^* \ e_i]$. Il est indiqué que $e_i$ soit la valeur $\min(E_i, e_i^*)$ où $E_i$ est l'épaisseur maximale de matériau déposé tel que les propriétés statiques soient satisfaites et $e_i^*$ l'épaisseur maximale de matériau physiquement déposable par le dispositif d'impression.

Il est alors particulièrement avantageux de maximiser l'épaisseur du matériau déposé lors de la fabrication d'un objet. En effet, en choisissant des épaisseurs les plus grandes possibles tout en s'assurant que les propriétés statiques sont satisfaites, le temps d'impression est alors moins élevé, ce qui permet d'augmenter la cadence de fabrication. L'homogénéité des matériaux déposés est en outre sensiblement améliorée.

L'étape suivante du procédé consiste à trancher la représentation 3D du composant en couches d'égale épaisseur par un ensemble de plans parallèles du volume de fabrication espacés de l'épaisseur h* minimale de couche d'impression et orthogonaux à l'axe Z d'impression. Il est ainsi obtenu, pour chaque objet remarquable, un ensemble de couches d'objet remarquable.

Le procédé permet ensuite de regrouper, pour chaque objet remarquable, ces couches d'objet remarquable en couches d'impression en fonction des caractéristiques des matériaux lors de leur dépôt mais également des autres objets, de la disposition tridimensionnelle relative des objets, des caractéristiques du dispositif d'impression et des intervalles d'épaisseur de matériau déposable.

Ainsi par exemple, si un objet a été tranché en 10 couches d'objet d'épaisseur égale à 10 $\mu$m et que l'épaisseur maximale de matériau déposable pour cet objet est de 50 $\mu$m, il est possible de regrouper les cinq premières couches d'objet en une première couche d'impression, et les cinq couches d'objets suivantes en une seconde couche d'impression. Lors de la fabrication, l'objet sera alors fabriqué en deux fois par l'impression successive des deux couches d'impression, c'est-à-dire l'impression de la première couche puis l'impression de la seconde couche.

Cependant le regroupement de ces couches d'objet doit tenir compte des caractéristiques des matériaux entrant dans la constitution des objets. Par exemple si l'objet précédemment décrit est constitué d'un matériau très fluide lors de son dépôt, il peut être nécessaire de préalablement construire une portion des objets adjacents dans le but de former un réceptacle pour ce matériau, ce qui peut imposer de définir une première couche d'impression inférieure en épaisseur à 50 $\mu$m.

De même si l'épaisseur des couches d'impression est trop importante, l'impression de ces couches d'impression peut entraver la fabrication ultérieure des autres objets car les moyens d'éjection n'ont plus accès à la partie de l'espace où doivent être déposés les matériaux pour la fabrication de ces objets.

De plus, l'épaisseur d'une couche d'impression ne peut être supérieure ni même égale à la distance séparant les moyens d'éjection de la surface sur laquelle doit être imprimée la couche d'impression, soit par impossibilité physique, soit par risque d'un mauvais dépôt de matériau si les moyens d'éjection sont sensiblement en contact avec la couche d'impression lors de son impression.

Ainsi le regroupement des couches d'objet a pour but de regrouper un maximum de couches d'objet entre elles tout en tenant compte des caractéristiques de la fabrication du composant multimatériaux 3D par un dispositif d'impression particulier.

Etape de détermination de trajectoires spatiales discrètes

L'étape 3 suivante du procédé est l'étape de détermination, pour chaque couche d'impression, d'une pluralité de trajectoires spatiales discrètes de parcours d'impression. C'est l'exécution en impression des trajectoires spatiales discrètes d'une couche d'impression qui fabrique cette couche.

Cette étape consiste à déterminer, pour chaque couche d'impression, un parcours d'impression constitué d'un ensemble de trajectoires spatiales discrètes de points d'éjection. Pour cela, cette étape consiste, dans un premier temps, à traduire chaque couche d'impression en distance entre deux éjections successives de gouttes, ou pas d'éjection. La valeur du pas d'éjection pour une couche d'impression est choisie dans l'intervalle de distance d'éjection précédemment défini associé à l'objet remarquable correspondant du composant à fabriquer. Le choix de cette valeur de pas d'éjection est effectué simultanément avec le choix d'un volume de matériau déposé et donc, vu du dispositif d'impression, d'une taille et d'une forme de gouttes, d'une hauteur d'éjection, d'une témpérature et d'une pression exercée sur la suspension de matériau lors de l'éjection du matériau dans les intervalles de paramètres d'impression correspondants associés, pour obtenir ladite épaisseur lors de l'impression. Ce choix est en outre déterminé en fonction d'un degré de rugosité souhaité de la surface de la couché d'impression, qui influence l'étalement et la dispersion, et donc l'arrangement des particules, du matériau qui sera ultérieurement déposé sur cette couche.

Ces choix peuvent être effectués de manière à minimiser le temps de fabrication du composant et/ou la complexité des lois de commande nécessaires pour le fonctionnement du dispositif d'impression utilisé. Ainsi parmi toutes les combinaisons possibles de valeurs des paramètres d'impression décrits ci-dessus, on peut choisir celle qui est caractérisée par le pas d'éjection le plus grand. Ceci permet alors aux moyens de déplacement de marquer un nombre d'arrêts minimisé au-dessus des points d'éjection et donc augmenter la rapidité de fabrication tout en assurant les propriétés statiques requises.

Une fois un pas d'éjection déterminé pour chaque couche d'impression, le procédé consiste à déterminer ensuite des trajectoires spatiales discrètes de points d'éjection pour chaque couche d'impression.

Le procédé consiste tout d'abord à considérer un maillage de la surface d'impression de ladite couche d'impression. Ce maillage est une représentation du maillage de l'espace induit par les moyens de déplacement de l'unité d'impression. De façon classique, un dispositif d'impression du type jet d'encre comporte des moyens de déplacement actionnés par des moteurs pas à pas. Du fait du déplacement par unité discrète de position des moyens de déplacement du dispositif, l'espace est donc échantillonné spatialement selon le ou les pas de déplacement des moyens de déplacement.

Il est à noter que cet échantillonnage de la surface d'impression n'est pas nécessairement orthonormal. En effet les moyens de déplacement peuvent être constitués de moyens de déplacement unidirectionnel se déplaçant selon des axes quelconques et des pas de déplacement quelconques.

Un mode de réalisation du procédé selon l'invention consiste à déterminer un pas d'éjection, pour chaque couche d'impression, de sorte que le pas d'éjection peut varier d'une couche d'impression à une autre pour un même objet.

Cependant le mode de réalisation préféré du procédé selon l'invention consiste à choisir un pas d'éjection unique pour l'ensemble des couches d'impression d'un objet remarquable. Ce choix permet de commander de manière plus simple les moyens de déplacement et de gagner en rapidité et fiabilité de fabrication

Le procédé consiste ensuite à déterminer les trajectoires spatiales discrètes pour satisfaire les propriétés statiques recherchées mais également pour optimiser l'arrangement des particules de matériaux et l'isotropie des objets remarquables et du composant à fabriquer. Un arrangement de particules optimal permet en conséquence d'obtenir une cohésion optimale des objets et donc du composant finalement obtenu, lequel présente donc une résistance mécanique maximisée. L'isotropie est une qualité importante d'un composant, car aucune direction n'est privilégiée dans le composant, ce qui diminue augmente la résistance mécanique du composant et évite des directions privilégiées de retrait, lors du frittage du composant fabriqué.

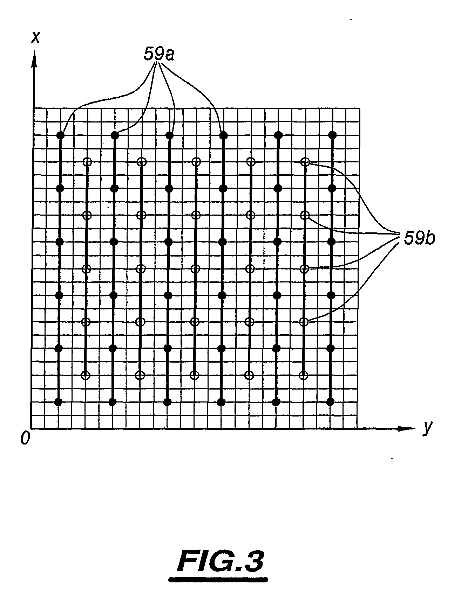

L'étape de détermination des trajectoires spatiales discrètes d'une couche d'impression va maintenant être décrite en relation avec la figure 3. On a représenté sur la figure 3, une vue en élévation d'une couche d'impression d'un objet remarquable de section carrée. Cet exemple a été choisi pour illustrer de manière simple l'étape de détermination de trajectoires spatiales discrètes d'une couche d'impression. Bien entendu, ce qui est décrit ci-dessous s'applique à des objets remarquables de forme quelconque.

Le procédé consiste dans un premier temps à définir un ensemble 59a de trajectoires spatiales discrètes caractérisées par une direction de parcours d'impression, c'est-à-dire une direction de déplacement suivie par les moyens d'éjection lors de l'impression, dans cet exemple selon l'axe X. Ensuite, un second ensemble 59b de trajectoires spatiales discrètes est obtenu par le décalage du premier ensemble de trajectoires spatiales discrètes d'un demi pas d'éjection dans la direction de parcours d'impression, ici l'axe X, et/ ou d'un demi pas dans la direction orthogonale à la direction de parcours d'impression, ici l'axe Y. Sur l'exemple de la figure 3, on a décalé le premier ensemble dans les deux directions. Ce décalage est rendu possible car, dans le dispositif d'impression selon l'invention, les pas d'éjection déterminés sont de deux ordres supérieurs au pas de déplacement des moyens de déplacement et donc au pas d'échantillonnage spatial de la surface d'impression de sorte qu'en première approximation tout point de la surface d'impression est atteignable. Si cela n'est pas le cas, le calcul du décalage doit tenir compte de manière explicite du pas d'échantillonnage spatial de la surface d'impression. Il tient compte également des dimensions de la section d'impression.

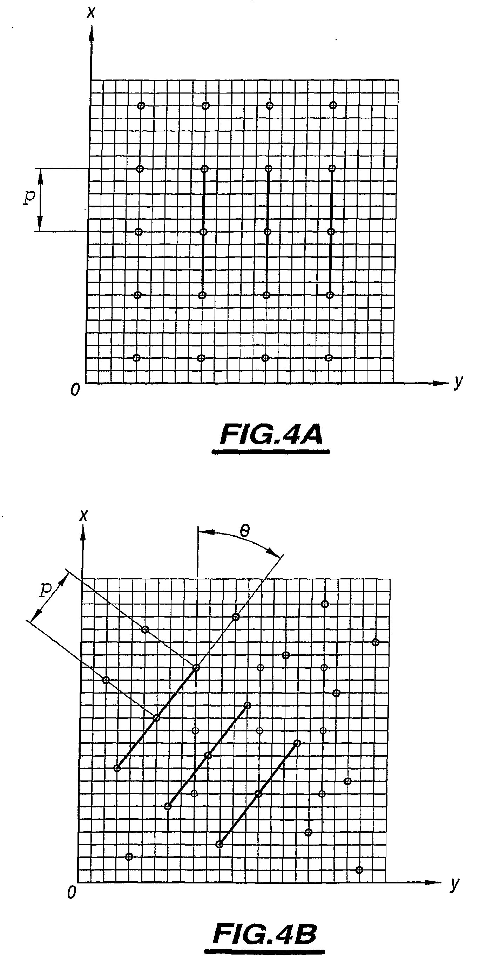

Le procédé consiste également, pour chaque objet, à déterminer les trajectoires d'une couche d'impression en fonction des trajectoires de la couche d'impression précédente par la détermination d'une direction de parcours d'impression et/ou d'une modulation de trajectoires spatiales discrètes. Sur les figures 4A et 4B sont représentées deux couches d'impression d'un objet devant être imprimées de manière successive. La première a être imprimée, représentée sur la figure 4A, est pourvue d'un ensemble de trajectoires spatiales discrètes caractérisées par une direction de parcours d'impression, ici selon l'axe X, et d'un pas d'éjection p. Les trajectoires spatiales discrètes de la couche suivante, représentées sur la figure 4B, sont obtenues en appliquant une rotation d'angle θ et de centre O, par exemple l'origine du repère orthogonal, à la direction d'impression de la couche précédente. Déterminer des directions de parcours d'impression différentes d'une couche d'impression à la suivante est particulièrement avantageux car cela permet de ne privilégier aucune direction particulière dans l'objet et donc dans le composant et optimise l'arrangement des particules.

De plus, avec un pas d'éjection identique pour deux couches d'impression successives, il est obtenu des points d'éjection impossibles à atteindre par simple translation dans la direction de parcours d'impression de la première couche, dans cet exemple l'axe X et/ ou dans la direction orthogonale à la direction de parcours d'impression, dans cet exemple l'axe Y d'une quantité multiple du pas d'éjection. Ceci a pour effet d'optimiser l'arrangement des particules sans diminuer le temps de fabrication du composant. L'angle de rotation θ est choisi simplement en divisant 360˚ par le nombre de couches d'impression de l'objet considéré, si cet angle est exprimé en degré.

Il est également possible de moduler le pas d'éjection d'une couche à l'autre pour, par exemple, optimiser la quantité de produit déposé par unité de surface. Cette modulation consiste à multiplier le pas d'éjection de la couche précédente par un facteur d'échelle et/ou à décaler d'un demi pas d'éjection dans la direction de parcours d'impression, ici l'axe X, et/ ou d'un demi pas dans la direction orthogonale à la direction de parcours d'impression, ici l'axe Y, les trajectoires spatiales discrètes de la couche d'impression courante pour obtenir les trajectoires de la couche d'impression suivante. Enfin il est possible de combiner la rotation de direction de parcours d'impression avec la modulation de la valeur du pas d'éjection et avec le décalage.

Etape de détermination des paramètres d'impression

L'étape 4 suivante du procédé permet d'établir pour chaque couche d'impression et chaque trajectoire spatiale discrète un ensemble de paramètres d'impression. Certains de ces paramètres, notamment la hauteur d'éjection des gouttes de matériau et le volume des gouttes de matériaux, ont déjà été déterminés lors de l'étape de détermination des trajectoires comme cela a été expliqué précédemment.

Le procédé consiste à déterminer pour chacun des matériaux un ensemble de paramètres commandant leur état à différents stades du processus de fabrication.

Tout d'abord, le procédé consiste à déterminer, pour chacun des matériaux, une température, une pression et un état de dispersion dans les moyens de stockages en fonction de sa nature et de ses conditions de dépôt notamment l'agencement des moyens d'éjection. Ceci a notamment pour but de conserver chaque matériau dans un état de conservation optimal. L'agitation permet en effet de commander l'état de dispersion du matériau et ainsi d'éviter la formation d'agglomérats de particules, propriété importante dans le domaine de la fabrication par impression du type jet d'encre, puisque des agglomérats de particules peuvent dégrader la qualité du composant fabriqué et peuvent obstruer les moyens d'éjection. La commande de la température et de la pression de chacun des matériaux dans les moyens de stockage permet également de contrôler la viscosité du matériau et conditionne favorablement le matériau pour une utilisation ultérieure dans les moyens d'éjection.

Le procédé commande également l'état de chaque matériau dans les moyens d'éjection et donc avant l'éjection, notamment la température et la pression, de sorte que les moyens d'éjection sont utilisés de manière optimale. Ensuite, l'éjection d'un matériau peut nécessiter une température spécifique de celui-ci lors de son éjection. Par exemple, si le matériau présente une température trop importante lors de l'éjection d'un matériau, une évaporation non désirée de solvant entrant dans la constitution du matériau et/ou une viscosité non satisfaisante du matériau peut alors apparaître lors de la formation des gouttes modifiant ainsi les caractéristiques du dépôt.

Une fois le matériau déposé, il est possible de le laisser évoluer de manière libre ou bien de commander cette évolution. Ainsi en commandant notamment la température du milieu dans lequel est déposé le matériau, par exemple l'air environnant le matériau déposé si la fabrication a lieu à l'air libre, et donc la température du matériau déposé, il est possible de commander de façon favorable l'évaporation du solvant, par exemple en commandant une évaporation uniforme et/ou plus rapide ou plus lente. Il est également possible de commander d'autres propriétés de l'environnement comme la pression, la nature du gaz dans lequel sont déposés les matériaux ou autres dans le but d'optimiser l'évolution du matériau une fois déposé.

Le procédé selon l'invention permet alors de déterminer les caractéristiques de l'environnement dans lequel est effectuée la fabrication du composant, notamment par la détermination pour chaque couche d'impression d'une température de l'environnement.

De même il peut être nécessaire de faire subir au matériau déposé un changement d'état. En effet, un matériau peut nécessiter d'être dans un premier état pour pourvoir être correctement stocké et/ou éjecté. Toutefois l'état final désiré de ce matériau peut être différent de ce premier état. Le changement d'état du matériau peut être obtenu par l'exposition de celui-ci à un rayonnement approprié, ou à une évolution temporelle prédéterminée de la température de l'environnement dans lequel le composant est fabriqué. Par exemple, en exposant certains systèmes céramiques à un rayonnement ultraviolet, ceux-ci photopolymérisent alors que d'autres matériaux s'agglomèrent sous l'effet d'une exposition à un rayonnement infrarouge.

Le procédé selon l'invention permet alors de déterminer, si cela est nécessaire, les caractéristiques du rayonnement permettant d'obtenir l'état final souhaité des matériaux. Pour cela, le procédé consiste à déterminer une longueur d'onde de rayonnement et une puissance de rayonnement pour chaque matériau et donc chaque couche d'impression qui nécessitent un tel traitement.

Enfin il est à rappeler que la hauteur d'éjection des gouttes de matériaux, leur volume ainsi que le pas d'éjection ont déjà été déterminés pour chaque couche d'impression et chaque trajectoire spatiale discrète.

Il est à noter que la détermination des paramètres d'impression relatifs à l'état des matériaux peut être exécutée simultanément à l'étape de détermination des objets remarquables ou lors de l'étape de détermination de la loi de séquencement spatial et temporel.

Etape de détermination de la loi de séquencement spatial et temporel

L'étape 5 suivante du procédé consiste à établir une loi de séquencement spatial et temporel des trajectoires spatiales discrètes. Comme il a déjà été expliqué précédemment, il est parfois nécessaire d'imprimer les couches d'impression suivant un ordre particulier fonction des propriétés des objets, de leur disposition tridimensionnelle relative et des caractéristiques du dispositif d'impression, ce qui signifie de manière équivalente d'exécuter en impression les trajectoires spatiales discrètes dans un ordre particulier.

De plus certains matériaux nécessitent entre chaque dépôt de gouttes d'une même trajectoire un temps de séchage nécessaire et/ou une immobilisation des moyens d'éjection pour commander de façon plus précise le dépôt de la goutte éjectée. On peut alors définir deux types de lois temporelles d'éjection de gouttes, à savoir un mode d'éjection de gouttes à la volée et un mode d'éjection de gouttes point par point. Dans le mode d'éjection de gouttes à la volée, les gouttes de matériau sont éjectées alors que les moyens d'éjection sont en mouvement. Quand cela est possible, ce mode d'éjection est privilégié car il augmente la vitesse de fabrication de l'objet. Dans le mode d'éjection de gouttes point par point, une goutte de matériau est déposée une fois les moyens d'éjection immobilisés au-dessus du point d'éjection.

Ainsi pour chaque couche d'impression, le procédé détermine le mode d'éjection des trajectoires spatiales discrètes en fonction des caractéristiques de l'objet considéré, notamment l'état du matériau lors du dépôt et les propriétés statiques recherchées. Le procédé permet également de déterminer une vitesse de déplacement des moyens d'éjection lors de l'exécution en impression d'une trajectoire spatiale discrète pour tenir compte du temps de séchage nécessaire entre deux éjections de gouttes successives.

Cette étape de détermination de la loi de séquencement permet également de déterminer un temps de séchage nécessaire entre l'impression de deux couches d'impression. L'ordre d'impression des couches d'impression peut être déterminé comme la solution d'un problème de minimisation du temps total d'impression de l'ensemble des couches d'impression. Par exemple si le temps de séchage nécessaire pour une couche d'impression est important, il peut être possible d'imprimer une couche d'impression autre que celle devant être superposée à la couche nécessitant un temps de séchage important. Il est ainsi possible par exemple de mettre en oeuvre un algorithme de recherche d'un ordre optimal d'impression des couches qui tienne compte de l'ensemble des caractéristiques de l'impression des couches d'impression.

Enfin l'étape de détermination de la loi de séquencement spatial et temporel permet d'introduire des séquences de nettoyage des moyens d'éjection dans la loi de séquencement spatial et temporel, ce qui minimise la probabilité de l'occurrence d'une obstruction des moyens d'éjection, événement qui peut être difficile à détecter suivant les matériaux déposés et leurs conditions de dépôt. Par exemple, une séquence de nettoyage peut être introduite à la fin de chaque séquence d'impression de 5 couches d'impression.

Les étapes du procédé qui viennent d'être décrites concernent l'établissement d'un ensemble de caractéristiques consiste également à commander ces caractéristiques lors de la fabrication.

Une étape du procédé consiste, lors de la fabrication du composant, en une étape de correction des erreurs d'impression survenue lors de l'impression de la couche venant d'être imprimée.

Lorsque l'impression d'une couche est terminée, une analyse morphologique de la surface de dépôt est effectuée. Cette analyse comprend une étape de détermination d'une représentation de la surface de dépôt suivie d'une comparaison de cette représentation avec une représentation de référence souhaitée. On obtient alors une représentation différentielle correspondant aux erreurs et imperfections d'impression résultantes de l'impression de la couche venant d'être imprimée. En fonction de cette représentation différentielle, il est possible soit de recalculer l'ensemble des caractéristiques de la couche suivante, soit d'introduire une couche d'impression supplémentaire présentant des trajectoires spatiales discrètes déterminées pour corriger localement les erreurs d'impression ou les mêmes trajectoires spatiales discrètes que la couche venant d'être imprimée. La dernière possibilité est préférée car elle permet une correction rapide et satisfaisante des erreurs.

En effet, l'expérience montre que la majorité des erreurs provient d'une quantité de matériaux déposée insuffisante. Par conséquent, une correction simple des erreurs consiste à déposer la quantité de matériaux manquante.

Le procédé va alors déterminer le volume des gouttes devant être éjectées nécessaires lors de l'exécution des trajectoires spatiales discrètes de la couche supplémentaire pour assurer la correction des erreurs. Ensuite on procède à l'impression de cette nouvelle couche d'impression et on réitère le processus d'analyse et de correction jusqu'à obtention d'un résultat satisfaisant.

Le procédé selon l'invention consiste également à commander le degré d'obstruction des moyens d'éjection. Si celui-ci dépasse une valeur seuil prédéterminée, la qualité de l'impression n'est plus assurée et il est alors nécessaire de procéder à un nettoyage des moyens d'éjection. Dès qu'une telle obstruction est détectée, le procédé consiste à interrompre l'impression en cours, à procéder à un parcage et à un nettoyage des moyens d'éjection et ensuite à reprendre l'impression à partir de l'état dans lequel elle a été stoppée. Un mode de réalisation du procédé selon l'invention, un test est mis en oeuvre pour savoir si la quantité de matériau manquante induite par les erreurs d'impression est supérieure à une valeur seuil prédéterminée, et si le résultat de ce test est positif, une obstruction des moyens d'éjection est alors détectée.

Enfin, comme il a été décrit précédemment, des valeurs de paramètres d'impression ont été déterminées pour satisfaire aux propriétés statiques du composant à fabriquer et aux caractéristiques des matériaux et du dispositif d'impression. Le procédé selon l'invention consiste alors à commander ces paramètres lors de la fabrication de sorte que lesdites valeurs déterminées de paramètres d'impression soient satisfaites.

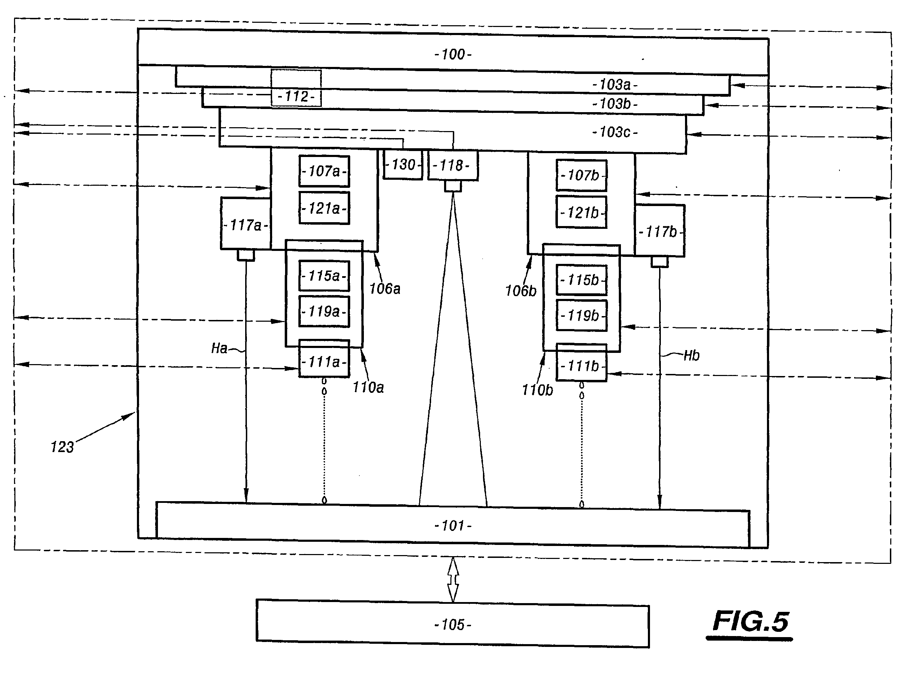

La description qui va suivre est relative au dispositif d'impression du type jet d'encre entrant dans la fabrication de composants multimatériaux selon le procédé de fabrication décrit précédemment. Il sera décrit en relation avec les figures 5 à 8.

La figure 5 représente un schéma de principe du dispositif d'impression selon l'invention. Le dispositif selon l'invention comprend une partie immobile composée d'un portique 100 anti-vibration horizontal et d'un support d'impression 101 horizontal. Le portique a pour fonction de maintenir de façon rigide l'ensemble du système, atténuer les perturbations d'ordre mécanique, c'est-à-dire les vibrations, et assurer une grande précision de parallélisme avec le support 101 horizontal sur lequel le composant multimatériaux est fabriqué. La fonction du support, outre celle d'être un support d'impression, est également celle d'atténuer les perturbations d'ordre mécanique, d'assurer une bonne planéité et d'assurer une grande précision de parallélisme avec le portique, et cela pour une plage de fonctionnement en température représentative de conditions normales de fonctionnement.

Le parallélisme entre le portique et le support est une caractéristique importante du fait que le système 103a, 103b,103c de déplacement du dispositif d'impression est fixé sur le portique. Ce système de déplacement permet un déplacement tridimensionnel selon trois axes indépendants. De façon typique il s'agit de trois platines 103a, 103b, 103c de déplacement unidimensionnel, chacune se déplaçant indépendamment selon un axe propre. Les trois axes forment un repère orthogonal. Deux premiers axes de déplacement de deux premières platines 103a, 103b sont horizontaux et forment, le cas échéant, en combinaison avec un pas de déplacement identique pour les deux premières platines 103a, 103b un repère orthonormal du plan d'impression, c'est-à-dire du plan supérieur 101 a du support d'impression. Le troisième axe de la troisième platine 103c est orthogonal aux deux premiers et par conséquent vertical.

Chacune de ces platines est actionnée par un moteur pas à pas, par exemple un moteur piézoélectrique de grande précision, dont le pas de déplacement est de l'ordre de la centaine de nanomètres. Chacune des platines est commandée via un contrôleur de puissance (non représenté), élément classique de commande des moteurs pas à pas, par une unité 105 de traitement d'informations.

Sur le système de déplacement est fixée une pluralité de réservoirs 106a 106b de stockage de matériau, un par matériau utilisé lors de la fabrication du composant multimatériaux. Chaque réservoir 106a, 106b comporte des moyens 107a, 107b de commande de l'état du matériau stocké qui agitent le matériau et commande sa température et sa pression. Ces moyens assurent le conditionnement du matériau dans des conditions optimales d'agitation, de température et de pression. Les moyens 107a, 107b de commande de l'état du matériau stocké sont reliés à l'unité 105 de traitement d'informations adaptée pour commander lesdits moyens 107a, 107b de commande de l'état du matériau stocké. Une description plus détaillée d'un réservoir selon l'invention sera fournie plus en détail par la suite.

Chaque réservoir est raccordé à des moyens d'éjection comprenant au moins une tête d'éjection 110a, 110b chargée de conditionner le matériau pour son éjection et au moins une buse d'éjection 111 a, 111 b raccordée à la au moins une tête d'éjection 110a, 110b. Chaque tête d'éjection 110a, 110b assure la connexion entre le réservoir 106a, 106b de stockage auquel elle est raccordée et à la au moins une buse d'éjection 111 a, 111 b raccordée à elle. Elle permet de commander en température et pression le matériau avant éjection pour satisfaire, non seulement aux spécifications requises pour l'impression mais également pour satisfaire les spécifications requises par les buses d'éjection 111 a, 111 b. En effet, certaines buses nécessitent par exemple pour leur fonctionnement une pression prédéterminée de matériau. Chaque tête d'éjection 110a, 110b comporte donc des moyens 115a, 115b de commande en température et en pression pour commander la température et la pression du matériau avant son entrée dans les buses d'éjection 111a, 111b. Lesdits moyens 115a, 115b de commande en température et en pression sont raccordés à l'unité 105 de traitement d'informations adaptée pour les commander.

Par ailleurs chaque tête d'éjection 110a, 110b comprend des moyens de nettoyage raccordés à un réservoir de liquide de nettoyage adaptés pour nettoyer cette dernière et nettoyer la au moins une buse d'éjection raccordée à elle. Une tête d'éjection selon l'invention sera décrite plus en détail dans la suite de la description.

Chaque buse d'éjection 111 a, 111 b permet la génération de gouttes de matériau. Typiquement il peut s'agir de buses à activation par membrane sollicitées par un élément piézoélectrique parallélépipédique, ledit élément parallélépipédique étant commandé en tension. La forme, la taille de gouttes éjectées et par conséquent le volume de matériau déposé par une telle buse est fonction du signal de tension appliqué à son élément piézoélectrique, en particulier de l'amplitude et du facteur de forme du signal appliqué. Dans le dispositif d'impression selon l'invention, chaque buse 111 a, 111 b est reliée via un amplificateur de tension (non représenté) à l'unité 105 de traitement d'informations adaptée pour la commander.

Par ailleurs le dispositif d'impression selon l'invention comporte une pluralité de capteurs et moyens d'acquisition de données.

Un premier capteur 112 de positionnement, préférablement inclus dans le système de déplacement, mesure la position des platines et donc des moyens d'éjection dans le plan horizontal et est raccordé à l'unité 105 de traitement d'informations. Sur la base de ces mesures et des trajectoires spatiales discrètes devant être imprimées, l'unité 105 de traitement d'informations met en oeuvre une loi de commande pour minimiser l'erreur entre les trajectoires spatiales discrètes souhaitées et les trajectoires spatiales discrètes réellement imprimées.

Des seconds capteurs 117a, 117b de positionnement mesurent les distances Ha, Hb, orthogonale à la surface de dépôt, entre les buses d'éjection et la surface de dépôt. Ces capteurs sont raccordés à l'unité 105 de traitement d'informations qui utilise leurs mesures pour mettre en oeuvre une loi de commande pour réguler les distances buse/ surface de dépôt Ha, Hb autour de valeurs nominales prédéterminées. De préférence, ces seconds capteurs 117a, 117b sont des capteurs à laser qui permettent d'effectuer des mesures de l'ordre du pas de déplacement de la troisième platine 103c verticale.

Un capteur 118 mesure les caractéristiques morphologiques de la surface de dépôt et est raccordé à l'unité 105 de traitement d'information qui utilise les mesures délivrées par ledit capteur pour déterminer une correction des erreurs d'impression. Il est à noter que ce capteur 118 peut être au moins un des seconds capteurs 117a, 117b de positionnement, s'il est par exemple utilisé un capteur du type laser dont la précision de mesure est de l'ordre de la longueur d'onde du rayon laser.

Des ensembles 119a, 119b de capteurs de température et de pression des matériaux dans les têtes d'éjection, un par tête d'éjection, mesurent la température et la pression des matériaux dans chaque tête d'éjection 110a, 110b et sont raccordés à l'unité 105 de traitement d'informations qui utilisent les mesures délivrées par lesdits ensembles 119a, 119b de capteurs pour déterminer une loi de commande des moyens 115a, 115b de commande en température et en pression des têtes d'éjection 110a, 110b.

Des ensembles d'acquisition 121a, 121b, un par réservoir de stockage, comprennent chacun un capteur de température, de pression, et des moyens d'acquisition de l'état de dispersion, mesurent la température, la pression et l'état de dispersion des matériaux stockés dans les réservoirs 106a, 106b. Lesdits ensembles d'acquisition 121a, 121b sont raccordés à l'unité 105 de traitement d'informations qui utilise ces mesures qui lui sont délivrées pour commander les moyens de commande en température, pression et état de dispersion des matériaux stockés dans les réservoirs 106a, 106b.

Le dispositif de fabrication selon l'invention comprend en outre des moyens d'acquisition (non représentés) du degré d'obstruction des buses d'éjections qui mesurent le degré d'obstruction des buses d'éjection 111 a, 111 b. L'unité 105 de traitement d'informations utilise les mesures du degré d'obstruction pour commander les moyens de nettoyages des têtes d'éjections et des buses d'éjection. De façon typique, les moyens d'acquisition du degré d'obstruction des buses d'éjection comprennent le capteur 118 de caractéristiques morphologiques et l'unité 105 de traitement d'information, comme il sera expliqué plus en détail par la suite. Lorsque l'unité 105 de traitement d'informations détermine que la quantité de matériau manquante pour une couche d'impression venant d'être imprimée, déterminée de la manière précédemment décrite, est supérieure à une valeur seuil prédéterminée, une obstruction des buses d'éjection est alors diagnostiquée et l'unité 105 de traitement d'informations commande alors les moyens de nettoyage des têtes d'éjection et des buses d'éjection.

Sinon, lorsque la taille des gouttes de matériau éjectée est suffisamment importante, les moyens d'acquisition du degré d'obstruction des buses d'éjection peuvent comprendre une caméra CCD qui détecte la présence ou l'absence de ces gouttes lors d'instants prédéterminés d'éjections de gouttes de matériaux. En cas d'absence de gouttes aux instants d'éjection, l'unité 105 de traitement d'informations commande alors les moyens de nettoyage des têtes d'éjection pour le nettoyage des têtes et des buses d'éjection.

Le dispositif d'impression selon l'invention comprend en outre une enceinte 123 hermétique qui définit une région de l'espace totalement isolée dans laquelle est fabriqué le composant. Par exemple cette enceinte peut contenir l'ensemble des moyens décrits précédemment. Cette enceinte comprend des moyens de commande des caractéristiques de l'environnement de dépôt notamment sa température, lesquels sont raccordés à l'unité 105 de traitement d'informations pour leur commande. Cette enceinte peut également être adaptée pour commander la pression, l'hygrométrie ou encore la nature du gaz de l'environnement et comprendre à cet effet l'ensemble des moyens nécessaires.

Par ailleurs une source de rayonnement 130 est également prévue et est raccordée à l'unité 105 de traitement d'informations. Cette source de rayonnement peut comprendre des lasers, des lampes flash à infrarouge ou autres, adaptés pour émettre les longueurs d'ondes et les puissances rayonnées nécessaires au passage d'un matériau d'un premier état à un second état final désiré.

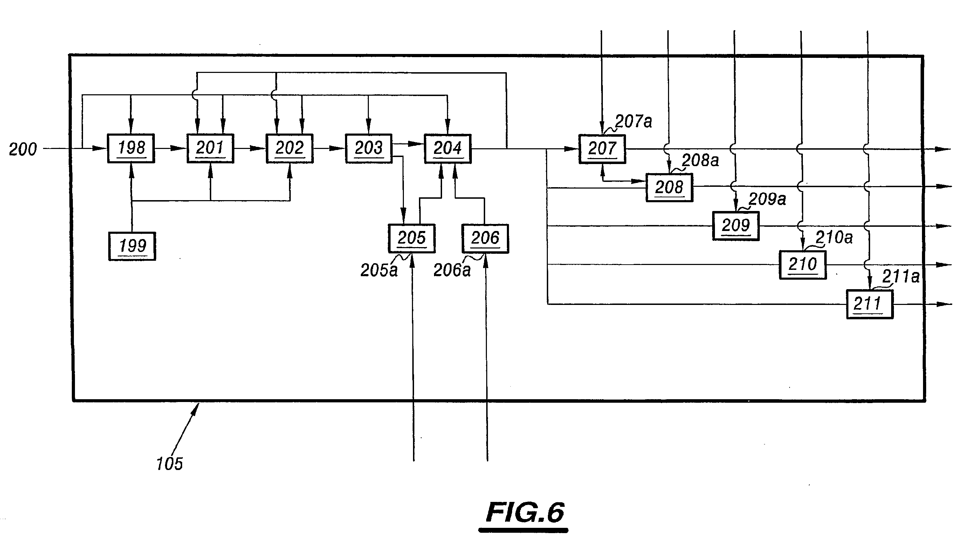

L'unité 105 de traitement d'informations de la figure 5 est maintenant décrite en relation avec la figure 6.

Une unité 198 de calcul adaptée, notamment, pour découper une représentation 3D du composant à fabriquer en objets remarquables a pour entrées ladite représentation 3D, le cahier des charges de fabrication du composant paramétré sous forme de données numériques et est raccordée à une base de données 199. La base de données 199 contient l'ensemble des résultats d'études menées antérieurement à la fabrication dudit composant. Ces études portent sur le choix de valeurs optimales de paramètres d'impression en fonction de la nature des matériaux, des caractéristiques du dispositif d'impression et des conditions de dépôt.

Ladite représentation 3D et le cahier des charges de fabrication sont entrés au niveau d'une entrée d'utilisateur 200 ou peuvent être stockés dans une unité de mémoire de l'unité de traitement d'information.

L'unité 198 de calcul est également adaptée pour trancher la représentation 3D du composant et déterminer, en fonction des données entrées et des informations stockées dans la base de données 199 concernant le composant à fabriquer, les couches d'impressions à imprimer de façon successive et l'ensemble des paramètres d'impression en mettant en oeuvre, par exemple de façon logicielle, l'étape de tranchage de la représentation 3D du composant à fabriquer du procédé selon l'invention tel que décrit précédemment en relation avec la figure 1.

L'utilisateur peut imposer, via l'entrée utilisateur 200 ou des données spécifiques stockées dans la base de données, une partie ou l'ensemble des caractéristiques du découpage et du tranchage de la représentation 3D comme, par exemple, l'épaisseur maximale d'impression telle que décrite dans l'étape de tranchage du procédé selon l'invention.

L'ensemble des couches d'impression ainsi que l'ensemble des intervalles de paramètres d'impression associés et/ou l'ensemble des paramètres fixés à des valeurs préalablement déterminées, comme cela a été décrit ci-dessus, sont alors fournis à une unité de calcul 201 adaptée pour déterminer, pour chaque couche d'impression, un ensemble de trajectoires spatiales discrètes, une hauteur d'éjection des gouttes de matériau ainsi qu'un volume de gouttes éjectées, en mettant en oeuvre, par exemple de façon logicielle, l'étape du procédé selon l'invention, telle que décrite précédemment en relation avec les figures 3, 4A et 4B. Cette unité de calcul 201 est également raccordée à la base de données 199 et à l'entrée d'utilisateur 200, l'utilisateur pouvant imposer une partie ou l'ensemble des caractéristiques des trajectoires spatiales discrètes comme par exemple le pas d'éjection d'une couche d'impression, le volume des gouttes éjectées, l'angle de la rotation θ, etc...

L'entrée utilisateur 200 peut consister avantageusement en une interface homme-machine appropriée.

L'unité de calcul détermine également l'ensemble des valeurs des paramètres d'impression relatifs à l'état des matériaux dans les réservoirs, dans la tête d'impression et une fois déposés, en mettant en oeuvre, par exemple de façon logicielle, l'étape de détermination des paramètres d'impression du procédé selon l'invention telle que décrite précédemment en relation avec la figure 1.

Les trajectoires spatiales discrètes, les couches d'impression et les paramètres d'impression associés déterminés par l'unité de calcul 201 ou par l'utilisateur sont alors fournis à une unité de calcul 202 adaptée pour déterminer une loi de séquencement spatial et temporel qui est également raccordée à la base de données 199 et à l'entrée utilisateur, l'utilisateur pouvant fixer une partie ou l'ensemble des caractéristiques de la loi de séquencement. Cette unité 202 détermine la loi de séquencement spatial et temporel en mettant en oeuvre l'étape de détermination de la loi de séquencement spatial et temporel du procédé tel que décrit précédemment en relation avec la figure 1. La loi de séquencement spatial et temporel est stockée séquentiellement dans l'ordre d'impression des couches d'impression dans une unité 203 de stockage de données.

Une représentation du composant fabriqué de manière idéale selon la loi de séquencement spatial et temporel déterminée par l'unité de calcul 202 est également stockée dans l'unité 203 de stockage des données. Cette représentation sert de référence pour calculer et corriger les erreurs d'impression.

Une unité 204 de pilotage est chargée de coordonner l'ensemble des moyens de stockage, de déplacement et d'éjection. Cette unité 204 de pilotage est raccordée à l'unité de stockage de données pour lire la loi de séquencement mémorisée. Elle est également reliée à une unité 205 d'analyse de morphologie de la surface de dépôt. Cette unité 205 d'analyse reçoit du capteur 118 de morphologie des mesures de la surface de dépôt sur une entrée 205a qui lui permettent de reconstruire ladite surface de dépôt. La surface de dépôt reconstruite est alors comparée à la surface de dépôt de la représentation du composant idéale stockée dans l'unité 203. L'unité 205 d'analyse calcule alors une surface de dépôt différentielle correspondant à la différence entre ces deux surfaces de dépôt, détermine en conséquence une couche d'impression supplémentaire représentative de la correction à apporter et signifie à l'unité 204 de pilotage qu'une correction doit être effectuée.

En réponse, l'unité 204 de pilotage reçoit ladite couche d'impression supplémentaire à imprimer et l'envoie à l'unité 201 de détermination des trajectoires spatiales discrètes qui calcule en conséquence un ensemble de paramètres d'impression, notamment les volumes de matériaux devant être déposés et par conséquent des tailles et des formes de gouttes éjectées, associés à un ensemble de trajectoires spatiales discrètes identique à l'ensemble des trajectoires spatiales discrètes de la couche d'impression venant d'être imprimée. Les paramètres ainsi que les trajectoires spatiales discrètes sont alors stockées dans l'unité 203 de stockage comme étant la première couche d'impression devant être imprimée. L'unité 204 de pilotage lit alors ladite loi de séquencement et la traite.

L'unité 204 de pilotage reçoit également d'une unité 206 de détermination du degré d'obstruction des moyens d'éjection une requête en nettoyage. Cette unité 206 de détermination reçoit régulièrement des mesures des moyens d'acquisition du degré d'obstruction des buses d'éjection sur une entrée 206a et détermine si les moyens d'éjection, c'est-à-dire au moins une buse d'éjection, sont obstrués. Si c'est le cas, une requête en nettoyage prioritaire est émise. L'unité 204 de pilotage stoppe l'impression, mémorise dans les moyens de stockage de données l'environnement d'exploitation lors de l'interruption et commande la séquence de nettoyage, consistant à parquer les moyens d'éjection et à procéder au nettoyage des moyens d'éjection. Une fois cette séquence terminée, l'environnement d'exploitation est rechargé et l'impression continue là où elle avait été stoppée.

En mode normal de fonctionnement, l'unité de pilotage lit la loi de séquencement spatial et temporel dans l'unité de stockage des données et génère en conséquence un ensemble de signaux de consigne pour les platines de déplacement et les buses d'éjection.

L'unité de pilotage génère également des signaux de consigne pour les réservoirs et les têtes d'éjection en fonction des valeurs des paramètres d'impression associés à la loi de séquencement en cours de traitement.

Un premier signal de consigne est un signal représentatif de la trajectoire spatiale sur la surface d'impression que doivent poursuivre les moyens d'éjection et par conséquent les deux premières platines se déplaçant selon un axe horizontal. Ce signal est envoyé à une unité 207 de commande mettant en oeuvre une loi de commande de poursuite de trajectoire. Cette unité reçoit sur une entrée 207a les mesures effectuées par le capteur de positionnement dans la surface d'impression pour mettre en oeuvre la loi de commande. Cette unité 207 calcule en conséquence le signal de commande approprié et l'envoie aux contrôleurs de puissance des deux premières platines de déplacement.

Un second signal de consigne est la trajectoire verticale que doivent poursuivre les moyens d'éjection et donc la platine de déplacement selon l'axe d'impression vertical. Cette trajectoire est construite à partir des différentes hauteurs d'éjections nécessaires à l'impression des couches d'impression. Ce signal est alors fourni à une unité 208 de commande de la troisième platine qui reçoit également sur une entrée 208a les mesures du capteur de positionnement vertical pour mettre en oeuvre une loi de commande de poursuite de trajectoire, de la même façon que précédemment. Cette unité 208 calcule donc un signal de commande et l'envoie au contrôleur de puissance de la platine de déplacement selon l'axe vertical. Les unités de commande 207 et 208 sont par ailleurs raccordées de sorte qu'elles échangent des signaux de synchronisation qui permettent de synchroniser les signaux de commande des platines pour permettre d'obtenir la trajectoire tridimensionnelle souhaitée.

Un troisième signal de consigne est un signal de consigne de commande des buses d'éjection. Ce signal est représentatif de la forme et de la taille des gouttes à éjecter et donc du volume des gouttes de matériaux devant être déposées ainsi que de leurs instants d'éjection. Ce signal est fourni à une unité 209 de commande de buses d'éjection qui reçoit également au niveau d'une entrée 209a , la sortie de l'unité de commande des deux premières platines de déplacement. Cette unité permet alors de générer un signal de commande des buses d'éjection synchronisé sur le signal de commande des deux premières platines. En effet, le signal de commande des buses d'éjection doit être synchronisé sur le signal de commande des deux premières platines puisque l'éjection de gouttes de matériaux s'effectue en des points prédéterminés de la trajectoires de ces platines. Pour cela l'unité 209 de commande des buses d'éjection peut par exemple comprendre une boucle à verrouillage de phase qui verrouille le signal de commande des buses d'éjection sur le signal de commande des deux premières platines. La sortie de l'unité 209 de commande de buses est alors fournie aux amplificateurs de tension des buses d'éjection du dispositif d'impression. Il est à noter que la synchronisation du déplacement et de l'éjection peut également être effectuée par l'unité de pilotage.

Un quatrième signal de consigne est un signal de consigne pour la commande de la source de rayonnement 130. Ce signal est représentatif de la longueur d'onde du rayonnement émis, de son énergie, de sa durée d'émission et donc sa puissance et des instants d'émission du rayonnement et est fourni à la source de rayonnement. Ce signal de consigne peut consister à émettre un flash après chaque dépôt de goutte, ou après le dépôt d'un nombre prédéterminé de gouttes. Il peut également consister à émettre un rayonnement constant pendant la fabrication selon le cas.

Une unité 210 de commande en température et pression des têtes d'éjection reçoit de l'unité de pilotage les consignes en température et pression et est chargée de réguler la température et la pression de chaque tête d'éjection en fonction de ces valeurs. Pour cela elle reçoit sur une entrée 210a des différents capteurs de température et pression des mesures de température et pression des matériaux dans les têtes d'éjection et calcule en réponse le signal de régulation nécessaire pour réguler ces différents paramètres autour desdites valeurs de références qu'elle envoie aux moyens de commande en température et pression des têtes d'éjection.

De la même façon, une unité 211 de commande en température, pression et agitation des matériaux stockés dans les réservoirs de stockage reçoit de l'unité de pilotage des valeurs de référence de température, pression et d'état de dispersion correspondant aux valeurs requises pour le conditionnement optimal des matériaux dans les réservoirs de stockage. Cette unité 211 de commande reçoit sur une entrée 211 a des capteurs de température, pression et des moyens d'acquisition de l'état de dispersion des mesures de température, pression et état de dispersion, calcule en retour des signaux de régulation pour réguler la température, la pression et d'état de dispersion desdites consignes et les envoie aux moyens de commande en température, pression et agitation des réservoirs, comme cela sera expliqué plus en détail par la suite.

De même, une unité de commande en température dans l'enceinte (non représentée) reçoit de l'unité de stockage des valeurs de référence de température correspondant aux valeurs requises pour l'impression des différentes couches d'impression. Cette unité de commande en température dans l'enceinte reçoit d'un capteur de température dans l'enceinte (non représenté) des mesures de température et calcule en réponse des signaux de régulation pour réguler la température autours desdites consignes en température dans l'enceinte et les envoie aux moyens de commande en température de l'enceinte.

En outre, les sorties des unités de commande 210 et 211 et de l'unité de commande en température de l'enceinte peuvent être sélectivement désactivées pour permettre à l'utilisateur de régler manuellement la température, la pression et l'agitation des matériaux dans les réservoirs de stockages, la pression et la température des matériaux des têtes d'éjections et la température dans l'enceinte par des moyens prévus à cet effet dans les réservoirs, les têtes d'éjection et l'enceinte.

La description de l'unité 105 de traitement d'information est une description fonctionnelle de celle-ci. Les moyens qui la composent peuvent être mis en oeuvre de façon logicielle ou matérielle et peuvent être répartis dans divers éléments du dispositif. Ainsi les unités de calcul 198, 201, 202, 203, l'unité d'analyse 205, l'unité 206 de détermination du degré d'obstruction des moyens d'éjection ainsi que la base de donnée 199 peuvent être mises en oeuvre de façon logicielle sur un ordinateur personnel et les différentes unités de commande 207 à 211 ainsi que l'unité de commande en température de l'enceinte peuvent être intégrées sous forme de carte à circuit imprimé dans les moyens qu'elles sont chargées de commander. Ces unités de commande peuvent également être mises en oeuvre sous forme logicielle dans un PC qui peut être celui décrit précédemment.

La description qui va suivre détaille les réservoirs de stockage de matériaux et les têtes d'éjections selon l'invention qui permettent de mettre en oeuvre de manière avantageuse les différentes fonctions décrites précédemment.

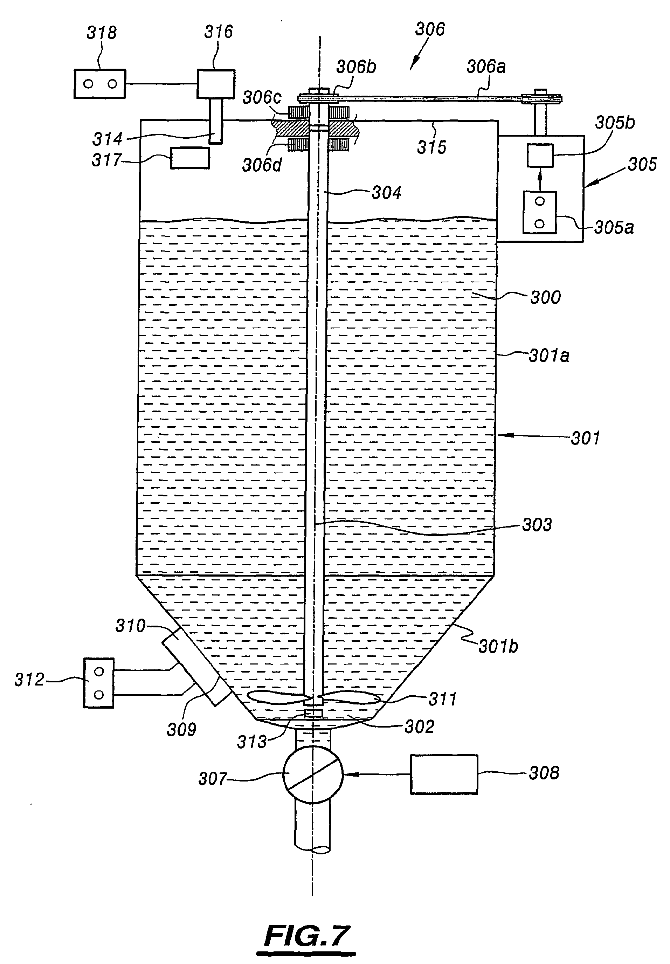

La figure 7 représente une vue en coupe d'un réservoir de stockage pour dispositif de fabrication du type jet d'encre selon l'invention. Le réservoir comprend un récipient 300. Celui-ci présente une surface interne 301 définissant un volume de préférence à symétrie de révolution pour éviter tout repli ou zone angulaire susceptible de définir une région de stagnation du matériau stocké, par exemple une partie cylindrique 301 a prolongé d'une partie conique 301 b qui sert à diriger le matériau stocké vers un orifice de sortie 302 pour permettre l'échappement du matériau stocké du réservoir.

Le réservoir comprend au niveau de son axe de symétrie 303, un arbre 304 interne au réservoir et entraîné en rotation par un moteur d'entraînement 305, pourvu d'un arbre de sortie, grâce à un système d'entraînement magnétique 306. Ce système d'entraînement magnétique comprend une courroie 306a entre l'arbre de sortie du moteur 305 et un arbre 306b disposé à l'extérieur du réservoir le long de l'axe 303 de symétrie. L'arbre 306b est disposé de telle sorte qu'une de ses extrémités est en vis-à-vis d'une extrémité supérieure de l'arbre 304, ces deux extrémités de l'arbre 306b et de l'arbre 304 étant adjacentes à la paroi supérieure du réservoir.

Un ensemble d'aimants permanents 306c, 306d est fixé sur chacune des extrémités de l'arbre 304 et de l'arbre 306b adjacentes à la paroi supérieure, de telle sorte que lorsque l'arbre 306b est entraîné en rotation par la courroie 306a quand l'arbre de sortie du moteur 305 est en rotation, l'arbre 304 est également entraîné en rotation.

Ce système d'entraînement de l'arbre 304 est particulièrement avantageux car il permet, d'une part, d'agencer de manière séparée le moteur 305 et l'arbre 304 et, d'autre part, d'assurer une étanchéité accrue, même lorsqu'une surpression est réalisée dans le réservoir, du fait que l'arbre n'est pas entraîné en rotation par un système nécessitant une ouverture dans la paroi supérieure du réservoir, une telle ouverture requérant un système spécifique d'étanchéité.

L'arbre 304 se prolonge en outre jusqu'à l'orifice 302 de sortie et au niveau de cet orifice de sortie 302, une pale d'agitation 309 est fixée audit arbre 304 entraîné en rotation. L'arbre entraîné en rotation, le moteur d'entraînement, le système d'entraînement magnétique et la pale d'agitation forment des moyens d'agitation du matériau stocké. Ils permettent de commander l'état de dispersion de celui-ci et diminuent la probabilité d'apparition d'agglomérats de particules et d'un phénomène de sédimentation, susceptible d'apparaître dans certains matériaux.

De façon typique, le moteur d'entraînement est un moteur à courant continu car l'agitation des matériaux communément utilisés dans la fabrication par impression du type jet d'encre ne requiert pas de forts couples en sortie du moteur et de grande vitesse de rotation et par conséquent de fortes puissances. Le moteur d'entraînement est commandé en tension et comprend de manière classique une interface de commande 305a laquelle est connectée à une source de tension qui délivre une tension représentative d'une vitesse de rotation caractéristique de l'état de dispersion souhaité du matériau et un circuit de commande 305b qui reçoit ladite tension délivrée en tant que consigne pour commander ledit moteur d'entraînement.

L'état de dispersion du matériau est commandé en utilisant les propriétés de commande du moteur. Le cisaillement du matériau par la pale d'agitation a pour effet de générer un couple résistant au couple de sortie du moteur dont l'intensité est fonction de l'état de dispersion du matériau stocké dans le réservoir. Le circuit de commande du moteur d'entraînement comprend de façon classique une boucle de régulation de la vitesse de rotation et peut comprendre en cascade une boucle de régulation du couple de sortie qui permettent d'assurer une vitesse de rotation constante correspondant à la consigne délivrée. Ceci a alors pour effet de réguler de façon simple l'état de dispersion du matériau. Il est bien sûr possible d'imaginer une commande du moteur d'entraînement pour faire varier la vitesse de rotation en fonction d'un profil d'état de dispersion souhaité sur la base de la mesure du couple résistant.

L'orifice de sortie 302 est en outre raccordé à une électrovanne commandable en ouverture 307 qui commande le flux de matériau sortant. Cette électrovanne peut être commandée en degré et durée d'ouverture de manière automatique ou manuellement par des moyens de commande d'ouverture 308 ce qui permet de commander la quantité de matériau sortant.

Egalement, au niveau de l'orifice de sortie 302 est agencé, la paroi du réservoir présente une zone 309 d'épaisseur faible sur laquelle est appliquée, du côté extérieur de la paroi, une surface d'échange thermique d'un module 311 de commande de la température comprenant un module à effet Peltier. Ce module 311 de commande de la température peut en outre comprendre une plaque chauffante pour chauffer le matériau stocké et ainsi étendre la gamme de température pour le matériau stocké. La faible épaisseur de la zone 309 permet de façon simple les échanges de chaleur entre le matériau stocké à l'intérieur du réservoir et le module 311 de commande de la température sans qu'une ouverture soit pratiquée dans la paroi du réservoir.

Le module à effet Peltier et la plaque chauffante sont raccordés à une interface 312 de commande qui peut être connectée à une source de signaux et qui délivre un signal représentatif de la quantité souhaitée de chaleur échangée entre module 311 de commande de la température et le matériau par unité de temps.

En outre au niveau de l'orifice est disposé un thermocouple 313 pour mesurer la température du matériau au niveau de l'orifice de sortie, laquelle est représentative de la température du matériau lors de l'éjection. Ce thermocouple est raccordé à une unité de traitement d'information à laquelle ce capteur fournit des mesures de température utilisées pour calculer des signaux de commande délivrés ensuite à l'interface 312 de commande.

L'intérêt de positionner les moyens d'agitation et de commande en température au niveau de l'orifice de sortie est de commander de façon précise l'état du matériau à sa sortie du réservoir, avant qu'il ne soit distribué aux autres éléments du dispositif d'impression.

Le réservoir selon l'invention comprend également une ouverture 314 située dans la paroi supérieure du réservoir. Cette ouverture est reliée à un système 316 de commande de la pression du matériau stocké. Pour commander ladite pression, une méthode consiste à remplir partiellement le réservoir de matériau et à commander la pression du gaz présent dans la région « libre » définie entre le matériau et la surface interne supérieure 315 du réservoir.

Pour cela, le système 316 de commande de pression comprend une pompe à vide pour pomper le gaz présent dans la région libre ce qui crée une dépression et un compresseur qui injecte du gaz comprimé dans la région libre, ce qui crée une surpression. Dans cette région libre, un capteur 317 de pression de gaz est disposé pour mesurer la pression du gaz de la région libre. Il fournit des mesures à un circuit de commande adapté pour commander la pression du gaz présent dans la région libre, par la commande de la pompe à vide et du compresseur en fonction d'une valeur de pression de gaz souhaitée. Ladite valeur de pression de gaz souhaitée est entrée au moyen d'une interface 318 de commande du système 316 de commande de pression laquelle est connectée à une source de signaux qui délivre un signal représentatif de la pression de gaz souhaitée.

On a ainsi décrit un réservoir de stockage de matériaux qui contient un ensemble de moyens pour commander la température, la pression et l'état de dispersion du matériau stocké. Le mode de réalisation précédemment décrit correspond à un mode de réalisation le plus complet. Les réservoirs ne comprenant qu'une partie de cet ensemble de moyens comme par exemple uniquement le module à effet Peltier pour le système de commande en température et le compresseur pour le système de commande de la pression, font également partie du cadre de la présente invention.

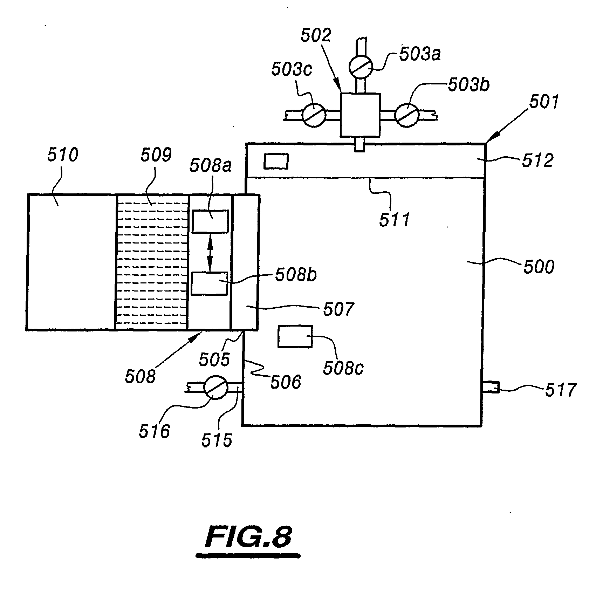

La figure 8 représente une vue schématique d'un mode de réalisation préféré d'une tête d'éjection pour dispositif de fabrication du type jet d'encre selon l'invention. Dans ce mode de réalisation, la tête d'éjection comprend un réservoir 500. Ce réservoir comprend dans sa paroi supérieure 501, une entrée d'alimentation 502 raccordée à une électrovanne commandable 503a d'alimentation en matériau, à une électrovanne commandable 503b d'alimentation en liquide de nettoyage et à une électrovanne commandable 503c de raccord à un circuit de commande de pression de gaz (non représenté).

La paroi interne 504 du réservoir présente une ouverture 505, de préférence sur la portion latérale 506 de la paroi interne. Cette ouverture sert de logement à une plaque métallique 507 d'interfacage entre le volume intérieur du réservoir et par conséquent le matériau quand celui-ci est présent dans le réservoir et un module à effet Peltier 508. Ce module à effet Peltier est commandé en tension de manière classique et relié à une interface de commande 508a qui est adaptée pour recevoir d'une source de tension, une tension représentative de quantité souhaitée de chaleur prélevée ou délivrée par le module à effet Peltier. Le module à effet Peltier comprend par ailleurs un circuit de commande 508b raccordé à l'interface 508a et adapté pour commander le module à effet Peltier pour, par exemple, réguler la température du matériau dans le réservoir autour d'une valeur de température souhaitée laquelle est délivrée par l'interface de commande 508b sous forme d'une tension représentative de ladite valeur de température souhaitée. Le circuit de commande reçoit pour la commande de l'effet Peltier des mesures en provenance d'un capteur de température 508e, par exemple un thermocouple, disposé dans le réservoir de façon à être plongé dans le matériau quand celui-ci est présent dans le réservoir.

Le module à effet Peltier est agencé en cascade avec un dissipateur thermique 509 formé par exemple d'un ensemble d'ailettes de dissipation thermique. Ce dissipateur thermique est lui-même agencé en cascade avec un ventilateur 510 adapté pour extraire la chaleur dissipée par le dissipateur thermique.

Lorsque l'électrovanne 503a d'alimentation en matériau est ouverte, du matériau en provenance de moyens de stockage de matériau (non représentés) coule dans le réservoir via l'entrée d'alimentation. L'électrovanne est fermée dès que le niveau de matériau dans le réservoir atteint un niveau prédéterminé, ici représenté par un trait pointillé 511. Ce niveau prédéterminé est choisi pour que la surface de la plaque 507 métallique d'interface orientée vers l'intérieur du réservoir soit entièrement en contact avec le matériau et qu'il reste un espace libre 512 entre ce niveau et la paroi supérieure 501 du réservoir. Cela suppose bien sûr que l'ouverture 505 dans la paroi interne du réservoir soit réalisée de la manière rendant ce choix possible.

L'espace libre entre le matériau et la paroi supérieure 501 est alors rempli de gaz dont il est avantageux de commander la pression. En commandant la pression de ce gaz, la pression du matériau au niveau de la surface de contact entre le matériau stocké dans le réservoir et le gaz de l'espace libre 512 est également commandée, et en conséquence la pression de l'ensemble du matériau stocké dans le réservoir 500. La commande de la pression du matériau contenu dans la tête d'éjection est essentielle car les buses d'éjection nécessitent généralement une pression de matériau prédéterminée, le plus souvent une dépression prédéterminée, pour fonctionner de manière correcte.

L'électrovanne commandable 503c de raccord à un circuit de commande de pression de gaz est raccordée à un circuit de commande de pression de gaz qui comprend un compresseur de gaz et une pompe à vide. Pour commander la pression du gaz de l'espace libre, l'électrovanne 503c est ouverte et soit la pompe à vide, soit le compresseur est commandé en fonction de la pression de gaz souhaitée. Pour obtenir une dépression, la pompe à vide est mise en route et une partie du gaz présent dans l'espace libre est aspirée par la pompe via l'entrée d'alimentation et l'électrovanne 503c jusqu'à obtention de la pression de gaz souhaitée. Pour obtenir une surpression, la commande inverse est pratiquée, c'est-à-dire que le compresseur est mis en route et envoie une quantité de gaz comprimé dans l'espace libre via l'entrée d'alimentation et l'électrovanne 503c jusqu'à obtention de la pression de gaz souhaitée.

Le circuit de commande de pression de gaz comprend un circuit de commande qui commande l'électrovanne commandable 503c, la pompe et le compresseur en fonction d'une pression de référence souhaitée et des mesures de pression délivrées par un capteur 512 de pression, par exemple un capteur à membrane, disposé dans l'espace libre.

Le circuit de commande de pression forme donc avec l'espace libre un moyen de commande en pression du matériau contenu dans le réservoir.

Le réservoir comprend en outre une sortie de purge 515 raccordée à une électrovanne commandable 516. Pour nettoyer le réservoir, l'entrée d'alimentation et la sortie d'échappement du matériau 516, l'électrovanne de purge 517 est tout d'abord ouverte pour purger le réservoir du matériau qu'il contient. Une fois la purge terminée, l'électrovanne commandable d'alimentation 503b en liquide de nettoyage est ouverte et un liquide de nettoyage en provenance d'un réservoir de liquide de nettoyage coule dans le réservoir et s'échappe principalement par la sortie de purge, ce qui constitue un premier nettoyage. Puis l'électrovanne de purge 517 est fermée et le liquide de nettoyage remplit le réservoir jusqu'au niveau 511.

La pression du liquide de nettoyage est alors réglée par les moyens de commande en pression pour commander la pression du liquide de nettoyage du réservoir et permettre ainsi au liquide de nettoyage de sortir du réservoir par la sortie d'échappement ce qui permet de nettoyer ladite sortie d'échappement et la ou les buses d'éjection qui sont raccordée(s) à la tête d'éjection par ladite sortie d'échappement. Le cas échéant il est également possible de commander le liquide de nettoyage présent dans le réservoir en température si cela est nécessaire. Le système de nettoyage décrit ci-dessus est donc incorporé à la tête d'éjection, évite ainsi d'utiliser une station de nettoyage spécialisée et présente l'avantage d'être compatible avec un large nombre de modèles de buses d'éjection.

Bien entendu la notion de matériau recouvre les matériaux les plus divers tels que, notamment, les systèmes céramiques, les systèmes métalliques, les polymères ou autres.

**Revendications**

**1.** Procédé de fabrication d'un composant multimatériaux tridimensionnel par impression du type jet d'encre de gouttes d'au moins un matériau en couches successives, comprenant au moins les étapes consistant à :

- découper (1) une représentation du composant multimatériaux en objets remarquables,
- trancher (2) la représentation du composant en couches d'impression en fonction desdits objets remarquables ;
- établir (3), pour chaque couche d'impression, une pluralité de trajectoires spatiales discrètes de parcours d'impression ;
- établir (4), pour chaque couche d'impression et pour chaque trajectoire spatiale discrète, un ensemble de paramètres d'impression, en fonction de la nature des matériaux déposés et de leurs conditions de dépôt :
- établir (5) une loi de séquencement spatial et temporel de parcours d'impression desdites couches d'impression et desdites trajectoires spatiales discrètes en fonction des objets, de leur disposition tridimensionnelle relative et des caractéristiques du dispositif d'impression, ce qui permet d'optimiser le processus de dépôt de chaque couche d'impression ; **caractérisé en ce que** ledit procédé consiste au moins :

- à déterminer, pour chaque couche d'impression, une première modulation de trajectoires spatiales discrètes de parcours d'impression :
- à déterminer, pour chaque couche d'impression, au moins une direction déterminée de trajectoire spatiale discrète de parcours d'impression ;
- à déterminer, pour deux couches d'impression successives d'un même objet, une seconde modulation de la trajectoire spatiale discrète de parcours d'impression d'une couche courante à la couche suivante, ladite modulation étant fonction du nombre de couches constitutives à déposer dudit objet, ce qui permet d'optimiser la cohésion de la structure finale dudit composant multimatériaux.

2. Procédé selon la revendication 1, **caractérisé en ce que** le tranchage de la représentation du composé multimatériaux consiste à maximiser la quantité de matériaux déposée par couche d'impression.

3. Procédé de fabrication selon la revendication 1, **caractérisé en ce que** ladite première modulation consiste à déterminer une seconde trajectoire spatiale discrète par un décalage spatial du pas d'éjection d'une première trajectoire spatiale discrète.

4. Procédé selon la revendication 1 ou 3, **caractérisé en ce que** ladite seconde modulation de la trajectoire spatiale discrète de parcours d'impression est une modulation de la direction de parcours d'impression, définie pour chaque couche d'impression de l'objet par rapport à un repère orthogonal, à chaque couche d'impression étant associée une direction spécifique différente d'une couche d'impression précédente à la couche d'impression suivante de l'objet.

5. Procédé selon l'une des revendications 1, 3 ou 4, **caractérisé en ce que** pour une éjection successive d'au moins une goutte de matériau selon un pas d'éjection déterminé, ladite seconde modulation consiste en une modulation d'amplitude et/ou de décalage spatial dudit pas d'éjection d'une couche d'impression précédente à la couche d'impression suivante de l'objet.

## Claims

1. A method of manufacturing a three-dimensional, multi-material component by inkjet-type printing with drops of at least one material in successive layers, consisting of at least the following steps:

   - cutting up (1) a representation of the multi-material component into remarkable objects;
   - cutting (2) the representation of the component into print layers as a function of said remarkable objects;
   - establishing (3), for each print layer, a plurality of discrete spatial print path trajectories;
   - establishing (4), for each print layer and for each discrete spatial trajectory, a set of printing parameters, depending on the nature of the materials deposited and the conditions of their deposition;
   - establishing (5) a rule for the spatial and temporal sequencing of the print paths of said print layers and of said discrete spatial trajectories as a function of the objects, their relative three-dimensional arrangement and the characteristics of the printing device, thus enabling optimization of the process of depositing each layer of print; **characterized in that** said method consists of at least the following steps:
   - determining, for each print layer, a first modulation of discrete spatial print path trajectories;
   - determining, for each print layer, at least one predetermined direction of discrete spatial print path trajectory;
   - determining, for two successive print layers of the same object, a second modulation of the discrete spatial print path trajectory from a current layer to the following layer, said modulation depending upon the number of constituent layers of the object to be deposited, thus enabling optimization of the cohesion of the final structure of said multi-material component.

2. A method according to Claim 1, **characterized in that** the cutting of the representation of the multi-material composite consists of maximizing the quantity of materials deposited per print layer.

3. A manufacturing method according to Claim 2, **characterized in that** said first modulation consists of determining a second discrete spatial trajectory by a spatial shift of the ejection step of a first discrete spatial trajectory.

4. A method according to Claim 1 or 3, **characterized in that** said second modulation of the discrete spatial print path trajectory is a modulation of the direction of the print path, defined for each print layer of the object relative to an orthogonal reference frame, each print layer being associated with a specific direction which differs from a preceding print layer to the following print layer of the object.

5. A method according to one of Claims 1, 3 or 4, **characterized in that** for a successive ejection of at least one drop of material according to a predetermined ejection step, said second modulation consists of a modulation of amplitude and/or of spatial shift of said ejection step from a preceding print layer to the following print layer of the object.

**Patentansprüche**

1. Verfahren zur Herstellung eines dreidimensionalen Formteils aus mehreren Materialien durch Tintenstrahldruck von Tropfen mindestens eines Materials in aufeinanderfolgenden Schichten, umfassend mindestens die folgenden Schritte:

- Zerschneiden, (1) einer Darstellung des Formteils in charakteristische Objekte;
- Aufteilen (2) der Darstellung des Formteils in Druckschichten entsprechend der charakteristischen Objekte;
- Ermitteln (3) mehrerer diskreter räumlicher Drucksterkentrajektorien für jede Druckschicht;
- Ermitteln (4) einer Gesamtheit von Druckparametern für jede Druckschicht und für jede diskrete räumliche Trajektorie in Abhängigkeit von den Eigenschaften der aufgebrachten Materialien und von deren Aufbringbedingungen;
- Ermitteln (5) einer Regel für eine örtliche und zeitliche Druckstrecken-Reihenfolgebildung der Druckschichten und der diskreten räumlichen Trajektorien in Abhängigkeit von Objekten, deren relativer, dreidimensionaler Anordnung und der Eigenschaften des Druckgerätes, wodurch der Vorgang des Aufbringens jeder Druckschicht optimiert werden kann;
**dadurch gekennzeichnet, dass** der Vorgang mindestens folgendes umfasst:
- Bestimmen einer ersten Modulation diskreter räumlicher Druckstreckentrajektorien für jede Deckschicht;
- Bestimmen mindestens einer festgelegten Richtung diskreter räumlicher Druckstreckentrajektorien für jede Druckschicht;
- Bestimmen einer zweiten Modulation diskreter räumlicher Druckstreckentrajektorien von einer aktuellen Schicht zu einer darauffolgenden Schicht für zwei aufeinanderfolgende Druckschichten desselben Objektes, wobei die Modulation von der Anzahl der aufzubringenden, das Objekt bildenden Schichten abhängt, wodurch der Zusammenhalt der Endstruktur des Formteils aus mehreren Materialien optimiert werden kann.

2. Verfahren nach Anspruch 1, **dadurch gekennzeichnet, dass** das Aufteilen der Darstellung des Formteils aus mehreren Materialien darin besteht, die pro Schicht aufgebrachte Materialmenge zu maximieren.

3. Verfahren nach Anspruch 1, **dadurch gekennzeichnet, dass** die erste Modulation darin besteht, durch eine räumliche Verschiebung des Auswurfabstandes einer ersten diskreten räumliche Trajektorie eine zweite diskrete räumliche Trajektorie zu bestimmen.

4. Verfahren nach Anspruch 1 oder 3, **dadurch gekennzeichnet, dass** die zweite Modulation der diskreten räumlichen Druckstreckentrajektorie eine Modulation der Druckstreckenrichtung ist, die für jede Druckschicht des Objektes im Verhältnis zu einer orthogonalen Referenz definiert ist, wobei mit jeder Druckschicht eine spezifische Richtung assoziiert ist, die von einer vorhergehenden Druckschicht zur nachfolgenden Druckschicht verschieden ist.

5. Verfahren nach einem der Ansprüche 1, 3 oder 4, **dadurch gekennzeichnet, dass** für einen aufeinanderfolgenden Auswurf mindestens eines Materialtropfens gemäß eines bestimmten Auswurfabstandes die zweite Modulation aus einer Amplitudenmodulation und/oder einer räumlichen Verschiebung des Auswurfabstandes einer vorhergehenden Druckschicht zu der nachfolgenden Druckschicht des Objektes besteht.

**_FIG.1_**

**_FIG.2_**

**FIG.3**

21

## FIG.4A

## FIG.4B

**FIG.5**

**FIG.6**

EP 1 660 306 B1

**_FIG.7_**

**FIG.8**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2002167101 A

**Littérature non-brevet citée dans la description**

• **M. Motte et al.** *J. Am. Ceram. Soc.,* 1997, vol. 80 (2), 486-494

• **J.H. Song et al.** *Journal of Materials Science,* 2002